# EUROPEAN PATENT APPLICATION

(11) **EP 2 458 480 A1**
(43) Date of publication of application: **30.05.2012**
(21) Application number: 09847563.5
(22) Date of filing: 23.07.2009
(51) Int. Cl.: G06F 3/041, G06F 3/045

(54) **PROTECTION PANEL PROVIDED WITH TOUCH INPUT FUNCTION FOR ELECTRONIC DEVICE DISPLAY WINDOW**

(71) Applicant: Nissha Printing Co., Ltd., Kyoto-shi, Kyoto 604-8551 (JP)
(72) Inventor: NAKAMURA, Kazuto, Kyoto-shi Kyoto 604-8551 (JP); NISHIKAWA, Kazuhiro, Kyoto-shi Kyoto 604-8551 (JP); KAI, Yoshihiro, Kyoto-shi Kyoto 604-8551 (JP)
(74) Representative: HOFFMANN EITLE
(86) International application number: PCT/JP2009/063178
(87) International publication number: WO 2011/010378

(57) **Abstract**

In a touch-input-function added protective panel (1) for an electronic instrument display window having an FPC (10) that takes out an electrical signal by way of a through hole (9a, 9b, 9c and 9d) made in a lower electrode panel (3), an adhesive layer (16) that bonds a lower electrode panel and an upper electrode sheet (2a) to each other, has a connection hole (16a) connected to the through hole, plural dot spacers (30) are fixed and arranged in the connection hole and between the lower electrode panel upper surface at the peripheral edge of the through hole and the upper electrode sheet (2), so as to be separated from one another, and further an electroconductive adhesive (15) is filled from the through hole into the connection hole, the gap interval of which is maintained by the dot spacers.

## Description

### Technical Field

The present invention relates to a touch-input-function added protective panel for an electronic instrument display window which is used for a portable information terminal such as a PDA (personal digital assistance) or a handy terminal, an OA (office automation) instrument such as a copying machine or a facsimile, a smart phone, a portable telephone, a portable game instrument, an electronic dictionary, a car navigation system, a small-sized PC (personal computer), any one of various home electrical appliances, or the like, and is excellent in reliability of its FPC connection region.

### Background Art

A casing in an electronic instrument, such as a portable telephone or a smart phone, is generally made of a combination of a front surface casing and a rear surface casing each made of a synthetic resin. Specifically, a protective panel is fixed onto the front surface of the front casing by melt-bonding or the like to protect a liquid crystal display window. As this protective panel, conventionally, a panel made of a transparent and colorless resin has been hitherto used. However, as electronic instruments have been made decorative, a decoration, such as trimming, has been applied thereto by printing.

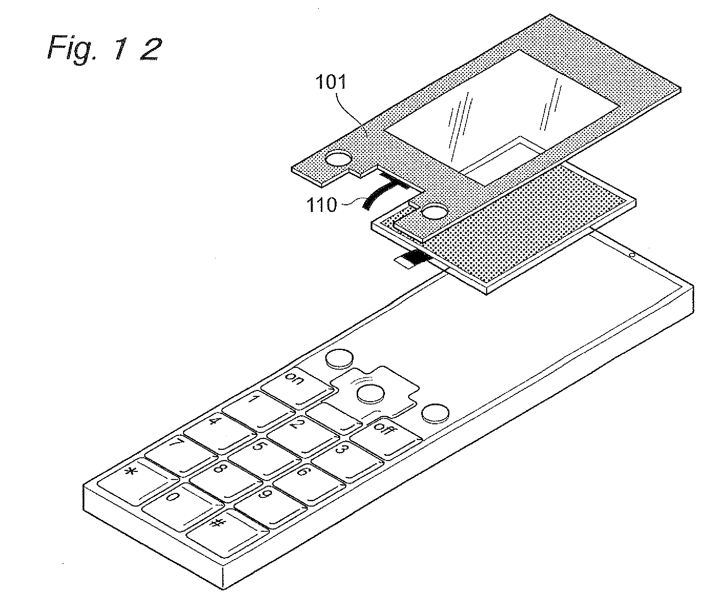

In recent years, about portable telephones, a protective panel 101 having an input device function, as illustrated in Fig. 12, has been expected as the next interface. The interface is disclosed in, for example, Patent document 1.

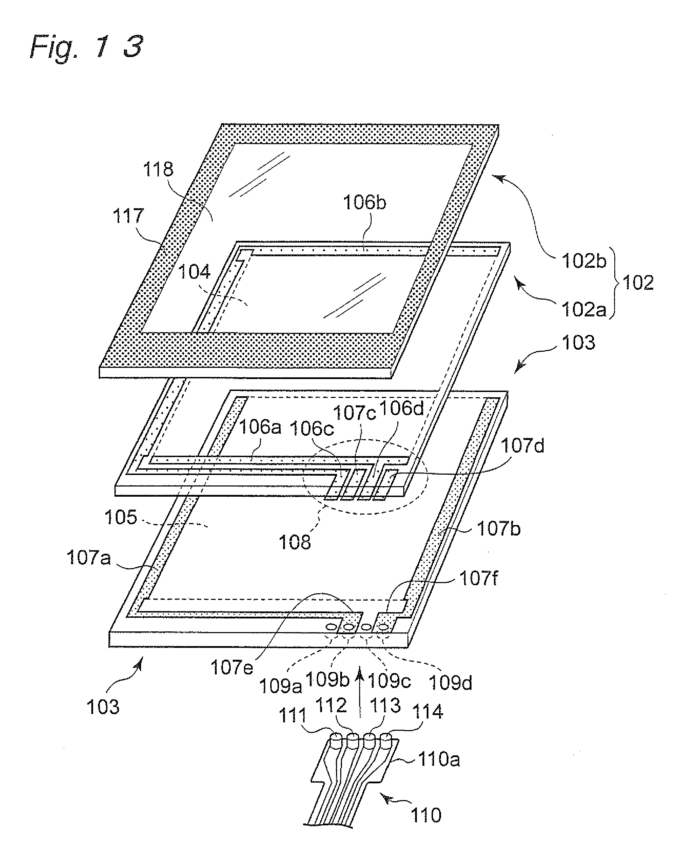

About the touch-input-function added protective panel 101 for an electronic instrument display window, a description will be made in more detail, using an exploded view of Fig. 13. In Fig. 13, the touch-input-function added protective panel 101 for an electronic instrument display window is a panel equipped with a lower electrode panel 103 having, on the upper surface of a nonflexible protective panel body, a lower transparent electrode 105, and lower circuits 107a and 107b located around the lower transparent electrode 105; an upper electrode sheet 102a having, on the lower surface of a flexible and transparent insulating film, an upper transparent electrode 104 located at a position opposite to the lower transparent electrode 105, and upper circuits 106a to 106d, 107c and 107d located around the upper transparent electrode 104; and a decorative sheet 102b having, in a flexible and transparent insulating film, a decorative layer 117 for hiding the lower circuits 107a an 107b and the upper circuits 106a to 106d, 107c and 107dby a pattern and forming a transparent window section 118.

On the inside surface of the upper electrode sheet 102a and that of the lower electrode panel 103, ITO (indium tin oxide) pieces, or the like are formed by sputtering or vacuum vapor deposition in a rectangular form as the transparent electrodes 104 and 105, respectively. On the upper electrode sheet 102a are formed band-form bus bars 106a and 106b, wherein a silver paste is used, which are connected to the transparent electrode 104 and are in parallel to each other. On the lower electrode panel 103 are formed band-form bus bars 107a and 107b, wherein a silver paste is used, which are extended in a direction orthogonal to the bus bars 106a and 10106b and are connected to the transparent electrode 105. About the individual bus bars 106a, 106b, 107a and 107b, their circuits are extended to a connection section 108 located at an edge region of the upper electrode sheet 102a, and then collected at the section, which is a single region.

The decorative sheet 102b is adhered onto the whole of the front surface (outside surface) of the upper electrode sheet 102a (hereinafter, a laminated film of the upper electrode sheet 102a and the decorative sheet 102b will be called a movable sheet 102). When the surface of the decorative sheet 102b is pressed with a finger, a pen, or the like, the movable sheet 102 is, in an integrated manner, bent down so that the respective transparent electrodes 104 and 105 formed on the inside surfaces of the upper electrode sheet 102a and the lower electrode panel 103, are brought into contact with each other. In this way, the input position is detected.

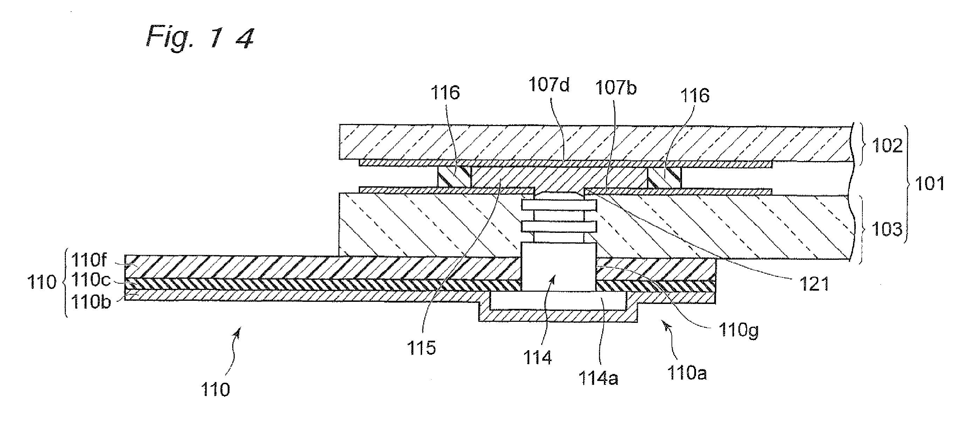

In Fig. 13, through holes 109a to 109d are made in parallel to the Z direction in the connection section 108 of the lower electrode panel 103, so as to correspond to individual electrode ends 106c, 107c, 106d and 107d in the connection section 108, unlike the touch-input-function added protective panel 101 for an electronic instrument display window described in Patent document 1. Correspondingly to these through holes 109a to 109d, four metallic pins 112 to 114 are stood at a connection side end 110a of an FPC (flexible printed circuit board) 110. The metallic pins 111 to 114 are electrically connected to the electrode ends 106c, 107c, 106d and 107d through an electroconductive adhesive not illustrated in Fig. 13 (see reference number 115 in Fig. 14). A method for the connection of the FPC from the rear surface of the lower electrode panel 103 is disclosed in Patent document 2.

In the pin-attached FPC 110 described in Patent document 2, at the connection side end 110a of the FPC 110, metallic pin fixing holes 110g are made in each of a film substrate 110f, and a circuit 110c as an electrically conductive section. Into the metallic pin fixing holes 110g are inserted the metallic pins 111 to 114, which each have a pin shaft portion and a head portion formed to have a larger diameter than the outside diameter of this pin shaft portion, from the circuit 110c side. A coverlay film 110b is adhered and bonded onto the circuit 110c and the film substrate 110f so as to cover the head portions (for example, reference number 114a in Fig. 14) of the metallic pins 111 to 114 (see Fig. 14).

Reference number 116 in Fig. 14 represents an adhesive layer for adhering the upper electrode sheet 102a of the movable sheet 102 and the lower electrode panel 103 to each other in their peripheral edge regions. In the adhesive layer 16 are made individual connection holes 121, to which the electroconductive adhesive (see reference number 115 in Fig. 14) is to be injected, so as to correspond to the individual electrode ends 106c, 107c, 106d and 107d in the connection section 108.

### Prior Art Documents

### Patent documents

Patent document 1: International Publication 2005/064451 pamphlet
Patent document 2: International Publication 2006/077784 pamphlet

### Summary of the Invention

### Issues to be Resolved by the Invention

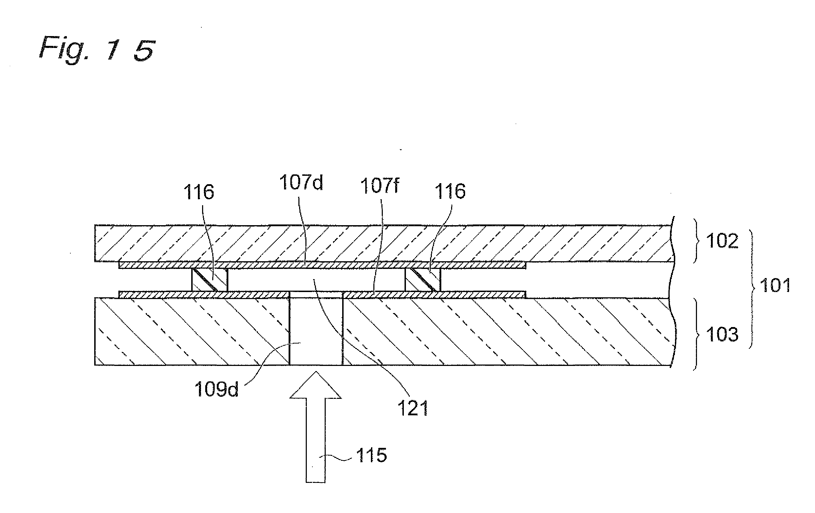

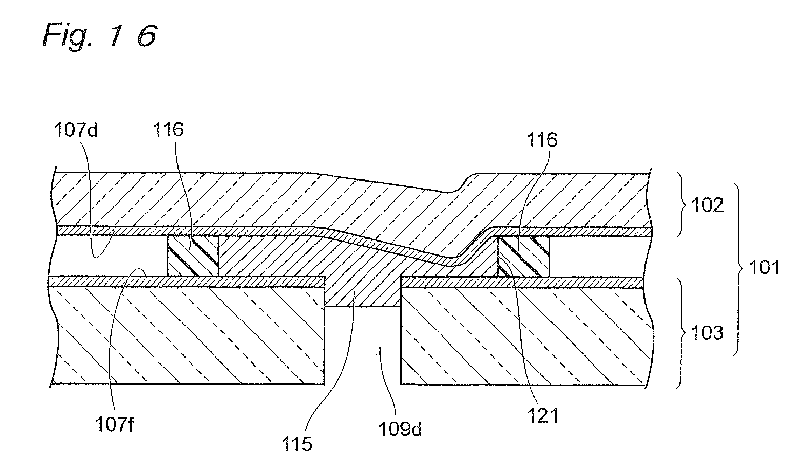

However, when the electroconductive adhesive 115 is injected from the connection hole 121 in each of the electrode ends 106c, 107c, 106d, and 107d, an issue is caused. Specifically, in the connection hole 121, which is a hollow region in the adhesive layer 116, naturally, a void (air gap) is made between the movable sheet 102 and the lower electrode panel 103 (see Fig. 15), and further the movable sheet 102 is, in an integrated manner, easily bent down; therefore, the size of the interval between the movable sheet 102 and the lower electrode panel 103 is easily varied. Accordingly, when the electroconductive adhesive 115 is injected therein, the movable sheet 102 is depressed over each of the connection holes 121, as illustrated in Fig. 16, so that the electroconductive adhesive 115 cannot be sufficiently injected. The connection with the electroconductive adhesive 115 in the connection section 108 depends on the filling degree of the electroconductive adhesive 115. In particular, in a case where, as seen in the electrode ends 107c and 107d, the electrode ends 107c and 107d are made of members different from the band-form bus bars 107a and 107b, the connection reliability depends thereon. When the electroconductive adhesive 115 cannot be sufficiently filled as described above, the connection reliability of the pin-attached FPC 110 falls.

The electroconductive adhesive 115 is cured by heating and drying, or curing at normal temperature (moisture curing, anaerobic curing, or two-component curing) ; thus, when the electroconductive adhesive 115 is cured in the state that the movable sheet 102 over the individual connection holes 121 are depressed as described above so that the electroconductive adhesive 115 cannot be sufficiently injected therein, the depressions in the movable sheet 102 are maintained. As a result, the external appearance quality of the touch-input-function added protective panel 101 becomes low for the following reason: about the protective panel 101, the whole of the front surface of the movable sheet 102 is to be an outer package of an electronic instrument, so that the depressions in the movable sheet 102 are to exist.

Even in a case where no depression is generated at the time of the injection of the electroconductive adhesive 115, the electroconductive adhesive 115 shrinks when heated and dried or cured at normal temperature, thereby generating depressions in the movable sheet 102 to decline the external appearance quality of the protective panel 101.

An object of the present invention is to resolve the issues as described above in the prior art, and provide a touch-input-function added protective panel for an electronic instrument display window which is excellent in connection reliability of its FPC, or the external appearance quality.

### Means for Resolving the Issues

In order to attain the object, the present invention is constructed as follows:
According to a first aspect of the present invention, there is provided a touch-input-function added protective panel for an electronic instrument display window, comprising:
   a lower electrode panel having, on an upper surface of a nonflexible protective panel body, a lower transparent electrode and a lower circuit located around the lower transparent electrode;
   an upper electrode sheet arranged on an upper side of the lower electrode panel, having, on a lower surface of a flexible and transparent insulating film, an upper transparent electrode located at a position opposite to the lower transparent electrode and an upper circuit located around the upper transparent electrode, and further bonded, at its peripheral edge region, to the lower electrode panel through an adhesive layer so as to form an inter-electrode gap between the upper transparent electrode and the lower transparent electrode;
   a decorative sheet arranged on an upper side of the upper electrode sheet, having, in at least one surface of a flexible and transparent insulating film, a decorative layer that hides the lower circuit and the upper circuit and forms a transparent window section, and further adhered onto an upper surface of the upper electrode sheet; and
   an FPC that takes out an electrical signal through a pin inserted into a through hole made in the lower electrode panel,
   wherein the adhesive layer has a connection hole connected to the through hole, plural spacers are fixed and arranged in the connection hole and between the upper surface, at the peripheral edge of the through hole, of the lower electrode panel and the upper electrode sheet, so as to be separated from one another, and an electroconductive adhesive is filled from the through hole into the connection hole, a gap interval of an inside of which is maintained by the spacers.

According to a second aspect of the present invention, there is provided the touch-input-function added protective panel for an electronic instrument display window according to the first aspect, wherein the spacers are dot spacers, and dots of the dot spacers are each fixed and bonded to at least one of the lower electrode panel and the upper electrode sheet.

According to a third aspect of the present invention, there is provided the touch-input-function added protective panel for an electronic instrument display window according to the first aspect, wherein the spacers are dot spacers, and dots of the dot spacers are each a particle fixed and bonded to at least one of the lower electrode panel and the upper electrode sheet.

According to a fourth aspect of the present invention, there is provided the touch-input-function added protective panel for an electronic instrument display window according to the third aspect, wherein the particle is fixed and bonded by fixing a supporting layer that fixes the particle, to at least one of the lower electrode panel and the upper electrode sheet.

According to a fifth aspect of the present invention, there is provided the touch-input-function added protective panel for an electronic instrument display window according to the fourth aspect, wherein the supporting layer is a layer having electroconductivity.

According to a sixth aspect of the present invention, there is provided the touch-input-function added protective panel for an electronic instrument display window according to any one of the first to fifth aspects, wherein the spacers have electroconductivity.

According to a seventh aspect of the present invention, there is provided the touch-input-function added protective panel for an electronic instrument display window according to any one of the third to fifth aspects, wherein the particle is spherical.

According to an eighth aspect of the present invention, there is provided the touch-input-function added protective panel for an electronic instrument display window according to any one of the first to fifth aspects, wherein a height size of the spacers is larger than a gap interval size of the connection hole that is maintained, in the connection hole in the adhesive layer, by the spacers.

According to a ninth aspect of the present invention, there is provided the touch-input-function added protective panel for an electronic instrument display window according to any one of the first to fourth aspects, wherein the spacers are arranged around a position of the upper surface of the lower electrode panel which corresponds to an inside of the through hole, so as to be in positions except the position, which corresponds to the inside of the through hole.

According to a tenth aspect of the present invention, there is provided the touch-input-function added protective panel for an electronic instrument display window according to the fourth or fifth aspect, wherein the supporting layer has a frame shape having, at a position of the upper surface of the lower electrode panel which corresponds to an inside of the through hole, a through hole, and the particles are fixed to regions of the supporting layer except the through hole in the supporting layer, whereby the particles are arranged around the position corresponding to the inside of the through hole. Effects of the Invention

In the touch-input-function added protective panel according to the present invention, between the upper surface, at the peripheral edge of a through hole, of its lower electrode panel and its upper electrode sheet and further in the connection hole in its adhesive layer, plural spacers are fixed and arranged so as to be separated from one another, and an electroconductive adhesive is filled from the through hole into the connection hole, the gap interval of which is maintained by the spacers. For this reason, the injection of the electroconductive adhesive can be filled smoothly into every portion of the connection hole made in the adhesive layer for bonding the lower electrode panel and the upper electrode sheet to each other. In other words, for example, the electroconductive adhesive is certainly filled into the connection hole to make it possible to connect the following electrically to one another with certainty: the electrode of the upper electrode sheet or the electrode of the lower electrode panel, which faces the connection hole; the electroconductive adhesive inside the connection hole; and a pin of the FPC inserted into the through hole connected to the connection hole. Thus, the reliability of electrical connection between the electrode(s) and the pin can be made high. Accordingly, the connection reliability of the pin-attached FPC, which depends on the filling degree of the electroconductive adhesive, is improved.

Furthermore, the protective panel has a structure wherein the electroconductive adhesive is filled from the through hole into the gap maintained by the spacers; thus, the injection of the electroconductive adhesive can be attained in the state that no depression is generated in the movable sheet, which is a laminated film of the upper electrode sheet and the decorative sheet. Thus, the external appearance quality of the protective panel is improved.

Also against the shrinkage of the electroconductive adhesive when the adhesive is heated and dried or cured at normal temperature, the spacers can resist the shrinkage stress. Thus, depressions in the movable sheet are decreased so that the external appearance quality of the protective panel is improved.

### Brief Description of the Drawings

These and other objects and features of the present invention will become clear from the following description taken in conjunction with the preferred embodiments thereof with reference to the accompanying drawings, in which:
Fig. 1 is an exploded perspective view showing a use example of a touch-input-function added protective panel for an electronic instrument display window according to an embodiment of the present invention;
Fig. 2 is an exploded perspective view showing the structure of the touch-input-function added protective panel for an electronic instrument display window according to the embodiment of the present invention;
Fig. 3A is an enlarged sectional side view showing a state immediately after an electroconductive adhesive is filled from a through hole in the touch-input-function added protective panel for an electronic instrument display window according to the embodiment of the present invention;
Fig. 3B is concerned with the protective panel in Fig. 3A, and is an enlarged plan view of a connection section of the lower surface of an upper electrode sheet when dot spacers are fixed to regions opposite to regions at the peripheral edges of the through holes on the lower surface side of a movable sheet;
Fig. 3C is concerned with the protective panel in Fig. 3A, and is an enlarged plan view of a connection section of an upper circuit 7d;
Fig. 3D is concerned with a modified example of the protective panel in Fig. 3A, and is an enlarged plan view of a connection section of an upper circuit 7d;
Fig. 3E is concerned with another modified example of the protective panel in Fig. 3A, and is an enlarged plan view of a connection section of an upper circuit 7d;
Fig. 4 is an enlarged sectional side view showing an FPC line connection structure of the protective panel according to the embodiment of the present invention;
Fig. 5 is an enlarged sectional side view showing a state immediately before the electroconductive adhesive is filled from the through holes in the protective panel according to the embodiment of the present invention;
Fig. 6A is an enlarged plan view of a connection section of a region 7f extended from a bus bar 7b in order to describe the necessity of a supporting layer of the protective panel according to the embodiment of the present invention;
Fig. 6B is an enlarged sectional side view of the vicinity of the connection section of the region 7f extended from the bus bar 7b in the state of Fig. 6A in order to describe the necessity of the supporting layer of the protective panel according to the embodiment of the present invention;
Fig. 6C is a plan view of the connection section of the region 7f extended from the bus bar 7b in order to describe the necessity of the supporting layer of the protective panel according to the embodiment of the present invention;
Fig. 6D is an enlarged sectional side view of the vicinity of the connection section of the region 7f extended from the bus bar 7b in the state of Fig. 6C in order to describe the necessity of the supporting layer of the protective panel according to the embodiment of the present invention;
Fig. 7A is an enlarged sectional side view of a protective panel according to a modified example of the embodiment of the present invention when dot spacers are fixed onto the upper surface side of its lower electrode panel;
Fig. 7B is concerned with the protective panel in Fig. 7A, and is a plan view of a connection region of the lower electrode panel when the dot spacers are fixed onto the upper surface side of the lower electrode panel;
Fig. 7C is concerned with the protective panel in Fig. 7A, and is an enlarged plan view of a connection section of a region 7f extended from a bus bar 7b when the dot spacers are fixed onto the upper surface side of the lower electrode panel;
Fig. 7D is concerned with a modified example of the protective panel in Fig. 7A, and is an enlarged plan view of a connection section of a region 7f extended from a bus bar 7b when dot spacers are fixed onto the upper surface side of its lower electrode panel;
Fig. 8 is an enlarged sectional side view of a protective panel according to another modified example of the embodiment of the present invention when dot spacers are fixed onto both of the lower surface side of its movable sheet 2 and the upper surface side of its lower electrode panel;
Fig. 9 is an enlarged sectional side view of a protective panel according to still another modified example of the embodiment of the present invention in order to illustrate a state that particles fixed and bonded onto its movable sheet sink slightly into its lower electrode panel;
Fig. 10A is a plan view of a protective panel according to a different modified example of the embodiment of the present invention when its support layer is arranged on the lower surface side of its movable sheet, so as to extend over its upper circuits adjacent to one another;
Fig. 10B is a plan view of a protective panel according to a further different modified example of the embodiment of the present invention when a supporting layer is arranged to extend over positions at the peripheral edges of four through holes on the upper surface side of its lower electrode panel;
Fig. 11A is concerned with a protective panel according to a further different modified example of the embodiment of the present invention, and is an enlarged plan view of a connection section of a region 7f extended from a bus bar 7b when plural prismatic spacers are fixed without using particles;
Fig. 11B is concerned with the protective panel in Fig. 11A, and is an enlarged sectional side view of the vicinity of the connection section of the region 7f extended from the bus bar 7b when the plural prismatic spacers are fixed without using particles;
Fig. 11C is concerned with a protective panel according to a further different modified example of the embodiment of the present invention, and is an enlarged plan view illustrating an example wherein plural prismatic spacers are fixed, without using particles, in regions (connection section) of its upper circuit which are opposite to regions at the peripheral edges of through holes;
Fig. 12 is an exploded perspective view illustrating a use example of a touch-input-function added protective panel for an electronic instrument display window of an electronic instrument, according to the prior art;
Fig. 13 is an exploded perspective view illustrating the structure of the touch-input-function added protective panel for an electronic instrument display window of an electronic instrument, according to the prior art;
Fig. 14 is an enlarged sectional view illustrating an FPC line connection structure of the touch-input-function added protective panel for an electronic instrument display window, according to the prior art;
Fig. 15 is an enlarged sectional view illustrating a state immediately before an electroconductive adhesive is filled from through holes in the touch-input-function added protective panel for an electronic instrument display window, according to the prior art;
Fig. 16 is an enlarged sectional view illustrating a state immediately after the electroconductive adhesive is filled from the through holes in the touch-input-function added protective panel for an electronic instrument display window, according to the prior art; and
Fig. 17 is a sectional view illustrating a gap between the movable sheet and the lower electrode panel of the embodiment of the present invention.

### Mode for Carrying Out the Invention

Before the description of the present invention proceeds, it is to be noted that like parts are designated by like reference numerals throughout the accompanying drawings.

Hereinafter, the present invention will be described in detail on the basis of embodiments illustrated in the drawings.

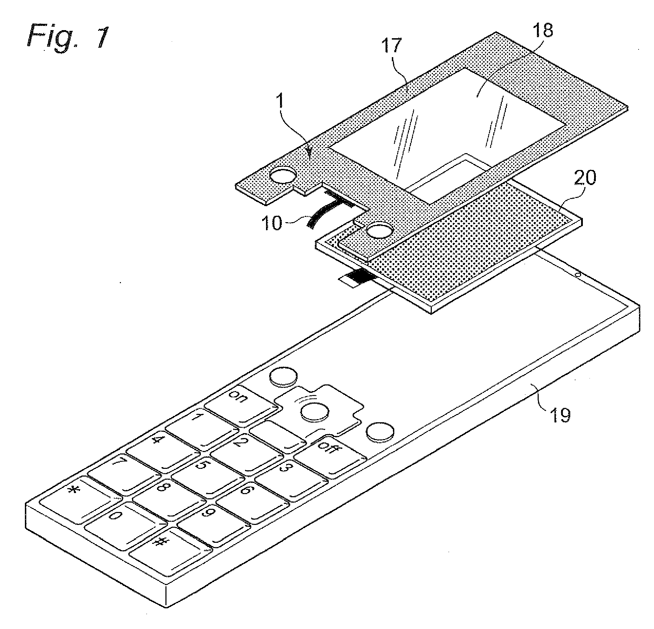

Fig. 1 is a view showing an example of the next interface for a portable telephone, or the like, and illustrates a state that in order for a liquid crystal display device 20 to be arranged inside the touch- input- function added protective panel 1, for an electronic instrument display window, according to an embodiment of the present invention, the protective panel 1 and the liquid crystal display device 20 are arranged in a casing 19 for an electronic instrument.

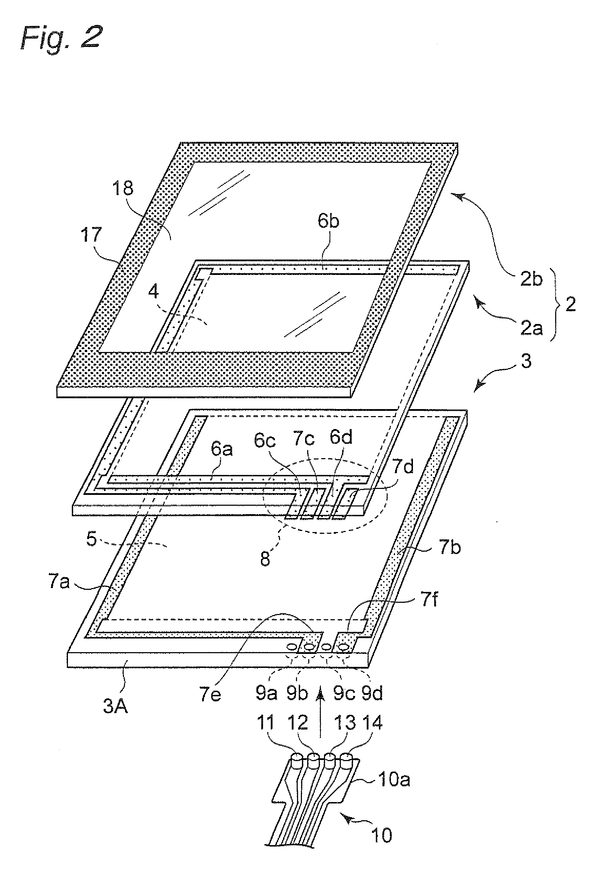

Fig. 2 is an exploded perspective view illustrating a basic structure of the touch-input-function added protective panel 1 for an electronic instrument display window, according to the embodiment of the present invention.

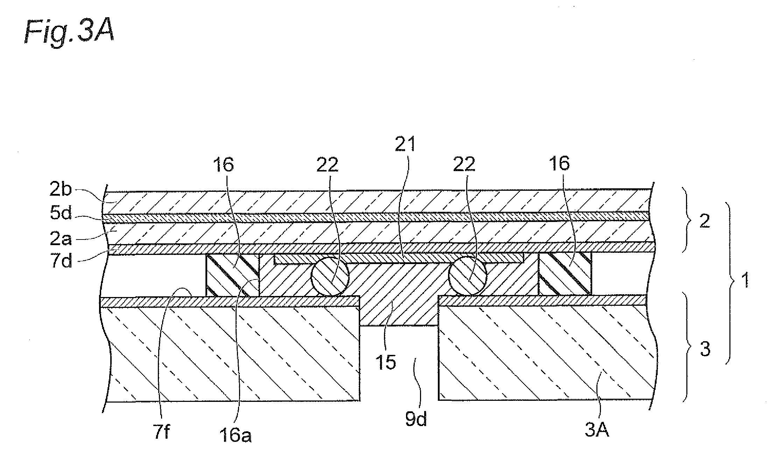

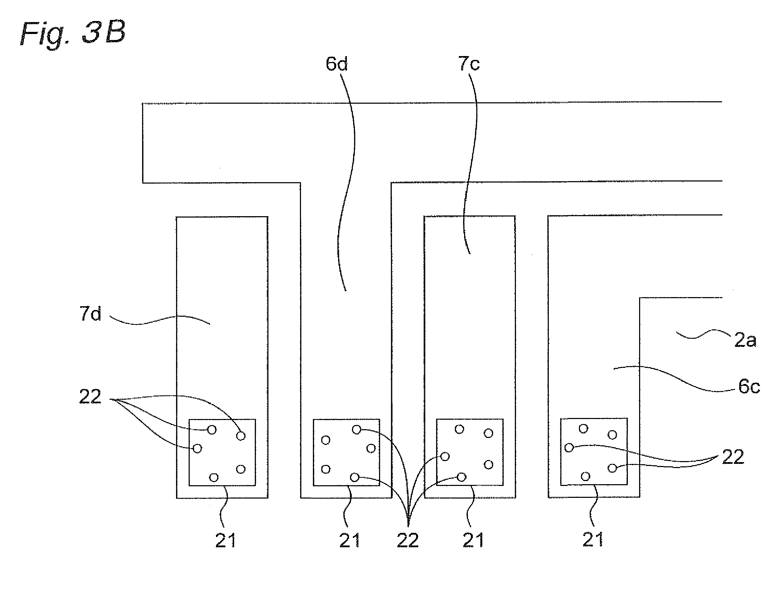

Fig. 3A is an enlarged sectional side view illustrating a state of the touch-input-function added protective panel 1 for an electronic instrument display window, according to the embodiment of the present invention immediately after an electroconductive adhesive 15 is filled thereinto. Fig. 3B is an enlarged plan view of a connection region 8 of the lower surface of an upper electrode sheet 2a showing a state that particles 22 are fixed and arranged by a supporting layer 21 in a region opposite to the region at the peripheral edge of a through hole 9d in Fig. 3A before the electroconductive adhesive 15 of the protective panel 1 is filled. This drawing, Fig. 3B, is a plan view of a state that the upper electrode sheet 2a is turned upside down and then the lower surface of the upper electrode sheet 2a is directed upwards in order that the situations of the particles 22 and the supporting layer 21 for supporting the particles 22 are well understandable.

In Fig. 2, the touch-input-function added protective panel 1 for an electronic instrument display window is constructed to have a transparent and rectangular plate-shaped lower electrode panel 3, the upper electrode sheet 2a, which is transparent and rectangular and is arranged outside of the lower electrode panel 3, a rectangular decorative sheet 2b arranged outside the upper electrode sheet 2a, and an FPC (flexible printed circuit board) 10 arranged inside the lower electrode panel 3.

The lower electrode panel 3 is constructed to have, on the upper surface of a nonflexible, transparent and rectangular protective panel body 3A, a rectangular lower transparent electrode 5 and band-form lower circuits 7a and 7b around the lower transparent electrode 5.

The upper electrode sheet 2a is constructed to have, on the lower surface of a flexible, rectangular and transparent insulating film, a rectangular upper transparent electrode 4 located at a position opposite to the lower transparent electrode 5, and band-form upper circuits 6a to 6d, 7c and 7d located around the upper transparent electrode 4. Of the upper circuits 6a to 6d, 7c and 7d, the circuits 6c and 6d are routing lines for giving outputs from the upper circuits 6a and 6b, respectively, to the outside. The circuits 7c and 7d are routing lines for connection to the lower circuits 7a and 7b, respectively.

The decorative sheet 2b is constructed to have, on a flexible, rectangular and transparent insulating film, a decorative layer 17 having a rectangular frame shape for hiding, by means of its pattern region, each of the lower circuits 7a and 7b of the lower electrode panel 3 and the upper circuits 6a to 6d, 7c and 7d of the upper electrode sheet 2a arranged at the peripheral edge region of the film, and defining a rectangular transparent window section 18.

The decorative sheet 2b is adhered onto the whole of the front surface (outside surface) of the upper electrode sheet 2a through a transparent adhesive layer 5d (see Fig. 3A), so as to constitute a movable sheet 2.

Out of the above-mentioned constituents, main constituting members each have a rectangular shape. However, in the present invention, the shapes thereof are not limited to the rectangular shape.

The material of the nonflexible protective panel body 3A of the lower electrode panel 3 may be, for example, a glass plate; a plate of an engineering plastic such as a polycarbonate, polyamide, or polyetherketone plastic; or a plate of plastic such as an acrylic, polyethylene terephthalate, or polybutylene terephthalate; or the like. It is allowable to adhere, onto a surface of such a plate where the lower transparent electrode 5 is to be formed, a film of an engineering plastic such as a polycarbonate, polyamide, or polyetherketone plastic; an acrylic; polyethylene terephthalate; polybutylene terephthalate plastic; or the like, thereby forming the lower electrode panel 3.

The material of the flexible and transparent insulating film of the upper electrode sheet 2a may be, for example, a film of an engineering plastic such as a polycarbonate, polyamide, or polyetherketone plastic; an acrylic; polyethylene terephthalate; polybutylene terephthalate plastic; or the like.

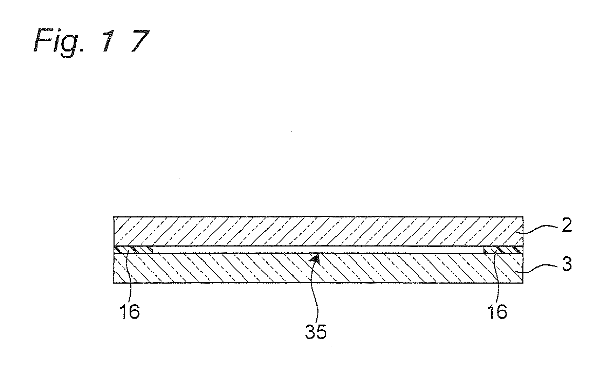

The upper electrode sheet 2a and the lower electrode panel 3 are arranged oppositely to each other to make a gap 35 (see Fig. 17) between the transparent electrodes 4 and 5, and are bonded to each other, through an adhesive, in individual peripheral edge regions of the upper electrode sheet 2a and the lower electrode panel 3. As each of the transparent electrodes 4 and 5, the following is formed into a rectangular form by vacuum vapor deposition, sputtering, ion plating, or CVD: a film of a metal oxide such as tin oxide, indium oxide, antimony oxide, zinc oxide, cadmium oxide, or indium tin oxide (ITO); a composite film made mainly of any one of these metal oxides; or a film of a metal such as gold, silver, copper, tin, nickel, aluminum, or palladium.

On the upper electrode sheet 2a, the upper transparent electrode 4 is formed, and further band-form bus bars 6a and 6b are formed around the upper transparent electrode 4 to be partially parallel to each other; the bus bars 6a and 6b are connected to the upper transparent electrode 4 as the upper circuits 6a to 6d, 7c and 7d, and formed by use of a metal such as gold, silver, copper, or nickel, or an electroconductive paste of carbon or the like.

On the lower electrode panel 3, the lower transparent electrode 5 is formed, and band-form bus bars 7a and 7b extended in a direction orthogonal to the bus bars 6a and 6b are formed, as the lower circuits 7a and 7b, around the lower transparent electrode 5. The band-form bus bars 6a, 6b, 7a and 7b can each be formed by a printing method such as screen printing, offset printing, gravure printing, or flexography; a photoresist method; a brush printing method; or the like.

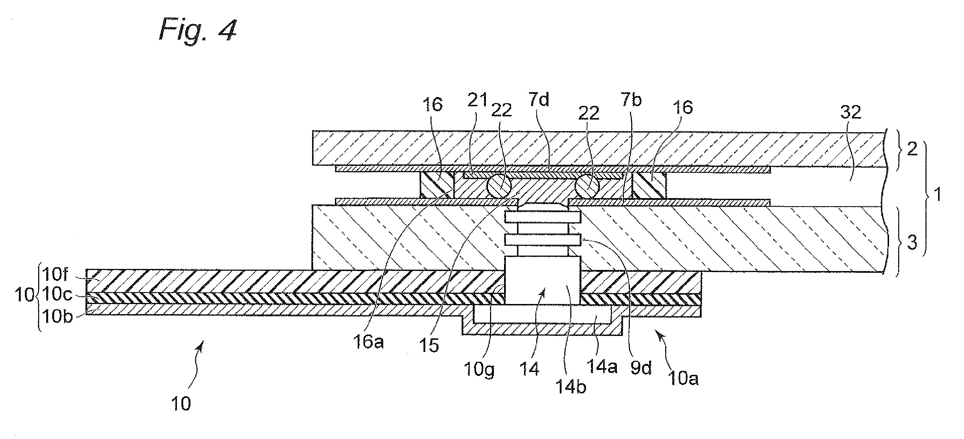

About the individual bus bars 6a, 6b, 7a and 7b, their circuits are extended to the connection region 8 located at one (the lower end edge in Fig. 2) of edge regions of the upper electrode sheet 2a, so as to be collected at the section, which is a single region. In Fig. 2, the bus bars 6a and 6b of the upper electrode sheet 2a are extended to the electrode ends 6d and 6c of the connection region 8, respectively; and further through the electroconductive adhesive 15 (see Fig. 3A, Fig. 4, and so on), which will be described later, in connection holes 16a in an adhesive layer 16, regions (routing lines) 7e and 7f extended from the respective bus bars 7a and 7b of the lower electrode panel 3 are connected to the respective electrode ends 7c and 7d formed, in the connection region 8 of the upper electrode sheet 2a, so as to be parallel to the electrode ends 6d and 6c. In a case where the inside diameter size of the connection holes 16a in the adhesive layer 16 for connecting these extended regions (routing lines) 7e and 7f, the electrode ends 7c and 7d, and pins 12 and 14 of an FPC 10 to each other through the electroconductive adhesive 15 is equal to the inside diameter size of through holes 9b and 9d, the connection hole inside diameter size is insufficient for attaining the electrical conduction certainly, and is preferably larger than the inside diameter size of the through holes 9b and 9d, for example, slightly larger than it. Similarly, in a case where the inside diameter size of the connection holes 16a in the connection layer 16 for connecting the electrode ends 6c and 6d to pins 11 and 13 of the FPC 10, respectively, through the electroconductive adhesive 15 is equal to the inside diameter size of the through holes 9a and 9c, the connection hole inside diameter size is insufficient for attaining the electrical conduction certainly, and is preferably larger than the inside diameter size of the through holes 9a and 9c, for example, slightly larger than it. It is necessary to make the inside diameter size of the connection holes 16a at lowest about 1.5 times larger than the inside diameter size of each of the through holes 9a to 9d.

Correspondingly to the electrode ends 6c, 7c, 6d and 7d in this connection region 8, the through holes 9a to 9d are made, respectively, in the lower electrode panel 3.

Furthermore, from these through holes 9a to 9d, electrical conductions to the electrode ends 6c, 7c, 6d and 7d are independently attained through the four metallic pins 11 to 14 of the FPC (flexible printed circuit board) 10 and the electroconductive adhesive 15 (see Fig. 3A, Fig. 4, and so on). In short, it is sufficient for the FPC 10 that electrical signals can be taken out from the through holes 9a to 9d, respectively. More preferably, the FPC 10 is formed as the pin-attached FPC 10, wherein the four metallic pins 11 to 14 are stood at a connection side end 10a of the FPC 10, correspondingly to the through holes 9a to 9d. In this case, the metallic pins 11 to 14 are electrically connected to the electrode ends 6c, 7c, 6d and 7d, respectively, through the electroconductive adhesive 15 not illustrated in Fig. 2 (see the electroconductive adhesive 15 in Fig. 3A and Fig. 4). A method for the connection of the FPC 10 from the rear surface of the lower electrode panel 3 is disclosed in Patent document 2. In the present invention, the structure of the FPC 10 may be a structure as described in the following; however, the structure is not limited thereto: in the connection side end 10a of the FPC 10, metallic pin fixing holes 10g are made in each of a film substrate 10f, and a circuit 10c as an electroconductive region; from the circuit 10c side into the metallic pin fixing holes 10g are inserted the metallic pins 11 to 14, which each have a pin shaft portion (for example, reference number 14b in the metallic pin 14) and a head portion (for example, reference number 14a in the metallic pin 14) formed to have a larger diameter than the outside diameter of this pin shaft portion; and a coverlay film 10b is adhered and bonded onto the circuit 10c and the film substrate 10f to cover the head portions (for example, reference number 14a in the metallic pin 14) of the metallic pins 11 to 14.

The decorative sheet 2b, which has the rectangular transparent window 18, is adhered onto the front surface of the upper electrode sheet 2a. In the decorative sheet 2b, the decorative layer 17 is constituted by a pattern region on a single surface of a flexible and transparent insulating film and around the transparent window 18, in other words, the layer 17 is formed to hide the upper circuits 6a to 6d, 7c and 7d, or the lower circuits 7a and 7b, or so on; the insulating film may be, for example, a film of an engineering plastic such as a polycarbonate, polyamide, polyetherketone plastic; an acrylic; polyethylene terephthalate; or polybutylene terephthalate plastic; or the like.

It is advisable that for the decorative layer 17, a colored ink is used which contains a resin as a binder and a pigment or dye in an appropriate color as a colorant, with as the resin being used polyvinyl resins, polyamide resins, polyester resins, polyacrylic resins, polyurethane resins, polyvinyl acetal resins, polyester urethane resins, or alkyd resins. It is advisable to use, as the method for forming the decorative layer 17, an ordinary printing method such as screen printing, offset printing, gravure printing, or flexography. In order to perform multi-color printing or gradation display, offset printing or gravure printing is particularly suitable.

The decorative layer 17 may be a metallic thin film layer, or a combination of a pattern printed layer with a metallic thin film layer. The metallic thin film layer is a layer for representing metallic luster as the decorative layer 17, and is formed by vacuum vapor deposition, sputtering, ion plating, or plating. In this case, the following may be used in accordance with the metallic luster color to be represented: a metal such as aluminum, nickel, gold, platinum, chromium iron, copper, tin, indium, silver, titanium, lead, or zinc; or an alloy or compound of any two or more of these metals. The film thickness of the metallic thin film layer is generally set to about 0.05 µm.

As described above, the decorative sheet 2b is adhered onto the whole of the front surface (outside surface) of the upper electrode sheet 2a through the adhesive layer 5d (see Fig. 3A), whereby the movable sheet 2 is constructed. When the surface of the decorative sheet 2b is pushed and pressed downwards with a finger, a pen, or the like, the movable sheet 2 is unified with the finger, the pen, or the like to be bent downwards, so that the transparent electrodes 4 and 5 formed on the respective inside surfaces of the upper electrode sheet 2a and the lower electrode panel 3 are brought into contact with each other. Thus, the input position is detected. For the adhesive layer 5d used for the adhesion, for example, the following is used: a polyacrylic resin, a polystyrene resin, a polyamide resin, vinyl chloride, vinyl acetate, an acrylic copolymer, or the like. The method for forming the adhesive layer 5d may be an ordinary printing method such as screen printing, offset printing, gravure printing, or flexography, or some other method.

The above has described the basic structure of the touch-input-function added protective panel 1 for an electronic instrument display window. The following will describe features of the embodiment of the present invention.

As described above, Fig. 3A is an enlarged sectional side view illustrating the state of the tauch-input-function added protective panel 1 according to the embodiment of the present invention immediately after the electroconductive adhesive 15 is filled thereinto. Of the through holes 9a to 9d, the through hole 9d is illustrated as a typical example thereof. The features of the embodiment of the present invention are structures as described in the following:
As illustrated in Figs. 3A and 3B, in this touch-input-function added protective panel 1, the particles 22, which are an example of spacers, for example, plural dot spacers 30, are fixed and arranged, preferably evenly, between the upper surface of the lower electrode panel 3 at the peripheral edges of the through holes 9a to 9d and the upper electrode sheet 2a, so as to be separated from one another. Specifically, the plural particles 22 are fixed onto an upper electrode sheet 2a region that is opposite to a region at the peripheral edge of the through hole 9d by means of the supporting layer 21, which will be described later, and then the lower electrode panel 3 and the upper electrode sheet 2a are bonded to each other through the adhesive layer 16, whereby the plural particles 22 are fixed and arranged between the upper surface of the lower electrode panel 3 at the peripheral edges of the through holes 9a to 9d, the upper electrode sheet 2a, and the individual connection holes 16a in the adhesive layer 16, which will be described later, so as to be separated from one another. After the upper electrode sheet 2a and the lower electrode panel 3 are adhered onto each other through the adhesive layer 16 in this way, the electroconductive adhesive 15 is injected from the through holes 9a to 9d into spaces that are between the upper surface of the lower electrode panel 3 at the peripheral edges of the through holes 9a to 9d and the upper electrode sheet 2a, that are inside the individual connection holes 16a in the adhesive layer 16, which will be described later, and further that have an interval size between the connection holes which is maintained by the particles 22. In this way, the electroconductive adhesive 15 is filled into the individual connection holes 16a.

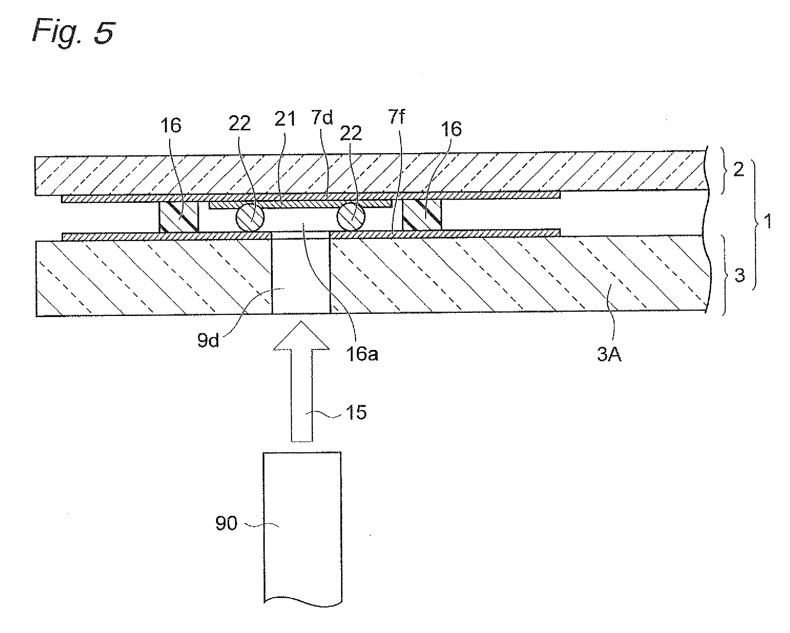

In Fig. 3A, reference number 16 represents the adhesive layer, which has a frame shape for adhering the upper electrode sheet 2a of the movable sheet 2 and the lower electrode panel 3 to each other in their peripheral edge regions. It is necessary that the individual connection holes 16a, in which the electroconductive adhesive (reference number 15 in Fig. 3A) is to be injected, are made in the adhesive layer 16, correspondingly to the individual electrode ends 6c, 7c, 6d and 7d in the connection region 8. In other words, the through holes 9a to 9d each made in the lower electrode panel 3 are made so as to be directed and connected to these connection holes 16a. From the through holes 9a to 9d, the electroconductive adhesive 15 is injected into the individual connection holes 16a by means of a dispenser 90 or the like (see Fig. 5). As a result, in the vicinity of the individual through holes 9a to 9d in the connection region 8, from which the individual connection holes 16a are excluded, the upper electrode sheet 2a of the movable sheet 2 and the lower electrode panel 3 are bonded to each other through the adhesive layer 16. The individual connection holes 16a are connected to the individual through holes 9a to 9d in the connection region 8, and are further made to be partitioned by the adhesive layer 16, the upper electrode sheet 2a of the movable sheet 2, and the lower electrode panel 3.

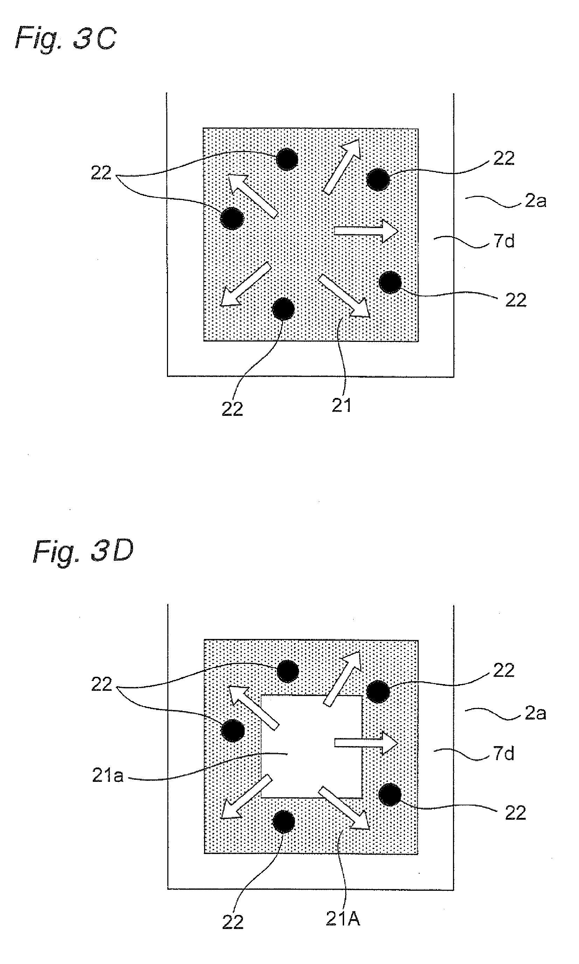

Fig. 3C is an enlarged plan view of the connection region of the upper circuit 7d in Fig. 3B. In Fig. 3C, white arrows each represent a flow of the electroconductive adhesive 15 injected from the through hole 9d in the lower electrode panel 3. Fig. 3C shows that the electroconductive adhesive 15 flows, as represented by the white arrows, through a space defined between the particles 22, which constitute an example of the dot spacers 30, so that the electroconductive adhesive 15 is filled into the connection holes 16a.

An example of the adhesive layer 16 is a double faced adhesive tape which has such a rectangular frame shape that regions for attaining inputs while a screen of the liquid crystal display device 20 or the like is seen through (the transparent window 18 in Fig. 2) are punched out, and is formed by punching out at least the individual connection holes 16a in portions of the rectangular frame shape. Instead of the double face adhesive tape, the adhesive layer 16 may be an adhesive layer formed by painting an insulating adhesive, for example, an aqueous or acrylic printing paste or some other printing paste.

By the particles 22, the size of each of the gaps in the individual connection holes 16a and between the lower electrode panel 3 upper surface at the peripheral edges of the through holes 9a to 9d and the movable sheet 2 is maintained (see Fig. 3A), thereby making it possible to fill the electroconductive adhesive 15 smoothly from the individual through holes 9a to 9d into every portion of the individual connection holes 16a in the adhesive layer 16. In short, the connection reliability of the FPC 10, which depends on the filling degree of the electroconductive adhesive 15, is improved. Additionally, the injection of the electroconductive adhesive 15 can be attained in the state that no depression is generated in the movable sheet 2 (see Fig. 5), so that the external appearance quality of the protective panel 1 is improved. Also against the shrinkage of the electroconductive adhesive 15 when the adhesive is heated and dried or cured at normal temperature, the particles 22 can resist the shrinkage stress of the electroconductive adhesive 15. Thus, depressions in the movable sheet 2 are decreased so that the external appearance quality of the protective panel 1 can be improved.

The filled electroconductive adhesive 15 is a product wherein electroconductive fillers are incorporated into a binder made of a silicone, epoxy, acrylic, or urethane resin. The electroconductive filler may be a powder of an electroconductive metal such as silver, gold, copper, nickel, platinum, or palladium; a filler wherein an inorganic insulator such as alumina or glass, an organic polymer such as polyethylene, polystyrene, or divinylbenzene, or the like is used as an electroconductive filler nucleus material, and any surface of the nucleus material is coated with an electroconductive layer of gold, nickel, or the like; or a filler wherein any surface of the nucleus material is coated with an electroconductive layer of carbon, graphite, or the like. The electroconductive adhesive 15 may be of either a thermosetting type or an ultraviolet curable type, and may be of either a one-component type or a two-component type. The electroconductive filler may be a filler in the form of flakes, spheres, short fibers, or the like. The method for painting the electroconductive adhesive 15 may be a dispenser method or the like.

The individual dots of the dot spacers 30, as an example of which the particles 22 function, may be formed, for example, by fixing and bonding the particles 22 onto the movable sheet 2 as illustrated in Fig. 3A. The particles 22 are particles having a particle diameter substantially equal to the size between the movable sheet 2 and the lower electrode panel 3, as illustrated in Fig. 3A.

The particle 22 is preferably made spherical. When the particle 22 is made spherical, the length sizes of the particle along the length and breadth directions thereof are substantially equal to the thickness size thereof; thus, in any state the particles 22 are fixed and bonded to the movable sheet 2, the size of the gaps between the lower electrode panel 3 upper surface at the peripheral edges of the through holes 9a to 9d and the movable sheet 2 and further in the individual connection holes 16a can be certainly kept at a predetermined value (for example, a size substantially equal to the particle diameter of the particle 22) (spacer function can be fulfilled). When the particle 22 is made into, for example, a flake form, the thickness size thereof is far smaller than the length sizes of the flake-form particles along the length and breadth directions (the thickness size is smaller than the gap size). Thus, depending on the state that the particles are fixed and bonded, the gap size may not be locally kept at the predetermined value.

When the thickness of the adhesive layer 16 is, for example, 50 µm, it is preferred to set the average particle diameter of the particles 22 into the range of 75 ± 10 µm (65 to 85 µm). The distribution of the particles 22 is set into, for example, 10 particles/mm².

The average particle diameter of the particles 22 is not always set into the range of 65 to 85 µm. When the thickness of the adhesive layer 16 is varied, the average particle diameter of the particles 22 is also varied. In other words, if the average particle diameter of the particles 22 is too small for the thickness of the adhesive layer 16, the movable sheet 2 cannot be supported. On the other hand, if the average particle diameter of the particles 22 is too large for the thickness of the adhesive layer 16, irregularities are generated in the surface of the movable sheet 2. In short, the matter that the average particle diameter of the particles 22 ranges from 75 ± 10 µm (65 to 85 µm) is an example, and is a numerical example when the thickness of the adhesive layer 16 is 50 µm. Thus, for example, when the average particle diameter of the particles 22 relative to the thickness of the adhesive layer 16 is represented by the ratio therebetween (the average particle diameter of the particles/the thickness of the adhesive layer), the ratio is from 1.3 to 1.7. If this ratio is smaller than 1.3, the movable sheet 2 cannot be supported. On the other hand, if this ratio is more than 1.7, irregularities are generated in the surface of the movable sheet 2.

About the number of the particles, the following can be described: if the number of the particles is too large, the electroconductive adhesive 15 is not easily filled; on the other hand, if the number of the particles is too small, the movable sheet 2 cannot be supported. Thus, in an example, a density of 10 particles/mm² is preferred.

The fixing and bonding of the particles 22, which has the spacer function, onto the movable sheet 2 can be attained by the supporting layer 21, which is, for example, rectangular (see Fig. 3A and Fig. 3B). The supporting layer 21 is formed specifically by painting, into a predetermined area (for example, the connection region of the band-form upper circuits 6a to 6d, 7c and 7d) of the movable sheet 2, a slurry wherein the particles 22 are numerously incorporated into a binder of a silicone, epoxy, acrylic, or urethane resin. The method for the painting may be a dispenser method, a screen printing method, or the like. For the fixing and bonding of the particles 22, which has the spacer function, onto the movable sheet 2, a well-known particle-fixing/bonding-technique may be adopted besides the means based on the supporting layer 21.

When the same silver paste is used for the supporting layer 21 and the electrode 7d, the compatibility between the two becomes good. Thus, the use is preferred for the connection reliability.

For example, the thickness of the supporting layer 21 is 20 µm, the diameter of the particles 22 is 75 µm, and the inside diameter of the through holes is 1.5 mm.

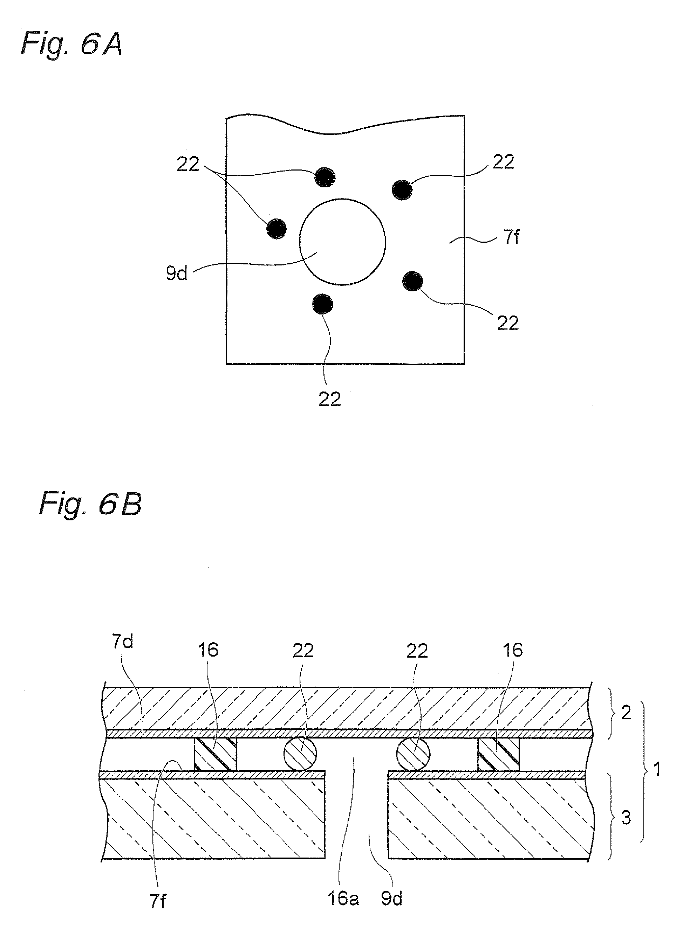

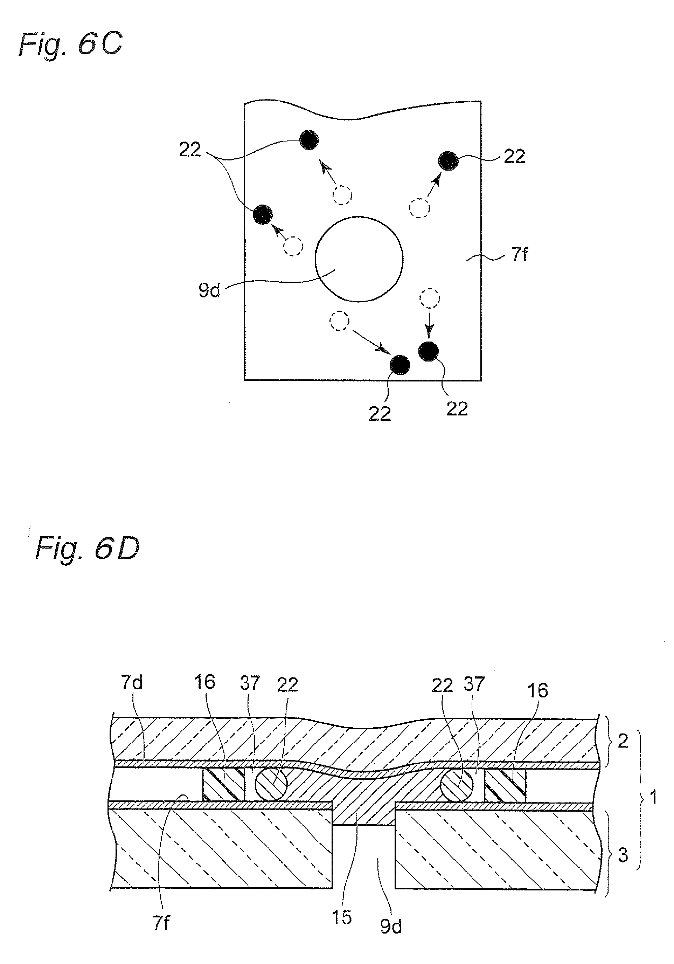

The necessity of the supporting layer 21 (that is, the necessity of fixing the particles 22) is described herein. If the particles 22 are not fixed onto the movable sheet 2 by means of the supporting layer 21 (that is, the particles 22 are not fixed onto the movable sheet 2), the following is unfavorably caused even when the particles 22 are evenly arranged at the peripheral edge of the through hole 9d as illustrated in Fig. 6A and Fig. 6B: when the electroconductive adhesive 15 is injected from the through hole 9d into the gaps in the individual connection holes 16a, the electroconductive adhesive 15 pushes the particles 22 inwards from positions at the peripheral edge of the through hole 9d, that is, the adhesive 15 pushes the particles 22 to positions near the inner wall faces of the individual connection holes 16a in the adhesive layer 16 therefrom (see Figs. 6C and 6D). As a result, the particles 22 supporting the regions at the peripheral edge of the through hole 9d are lost so that the size of the gap of each of the connection holes 16a at the peripheral edge of the through hole 9d cannot be kept at the predetermined value. Moreover, as a result of the shift of the particles 22 near the adhesive layer 16, the electroconductive adhesive 15 cannot go around to enter the gap between the particles 22 and the adhesive layer 16, so that a space 37 may remain between the electroconductive adhesive 15 and the adhesive layer 16. Thus, the connection reliability falls.

On the other hand, when the particles 22 are fixed onto positions at the peripheral edge of the through hole 9d by means of the supporting layer 21 (that is, the particles 22 are fixed onto the movable sheet 2), the following can be attained even when the electroconductive adhesive 15 is injected from the through hole 9d into the gaps of the individual connection holes 16a: by the electroconductive adhesive 15, the particles 22 are not shifted from the positions at the peripheral edge of the through hole 9d, so that the size of the gap of each of the connection holes 16a can be certainly kept at the predetermined value at the peripheral edge of the through hole 9d. Moreover, the electroconductive adhesive 15 can go around the particles 22, so that the space 37 does not remain between the electroconductive adhesive 15 and the adhesive layer 16. Thus, the connection reliability can be made high.

The shape of the supporting layer 21 is not limited to a rectangular shape, and may be any shape.

For example, Fig. 3D is an enlarged plan view of the connection region of the same upper circuit 7d as in Fig. 3C in a case where the supporting layer 21 is a supporting layer 21A in a rectangular frame shape. If in Fig. 3D the particles 22 are fixed to a region of the lower electrode panel 3 which is opposite to the through hole 9d (the central region of the supporting layer 21), an obstacle is caused at the time of filling the electroconductive adhesive 15 from the through hole 9d into the connection holes 16a. Thus, the adhesive 15 may be unevenly injected. In order to prevent this, the particles 22 are set not to be fixed to a region of the lower electrode panel 3 opposite to the through hole 9d (the central region of the supporting layer 21). For the setting, it is allowable to make a rectangular hole 21a without laying the supporting layer 21 in this region to make the supporting layer 21A into a rectangular frame shape, thereby making it easy to fill the electroconductive adhesive 15 from the through hole 9d into the connection holes 16a. As described herein, by the supporting layer 21A, which has the rectangular frame shape, the particles 22 are fixed to a region of the lower electrode panel 3 which is opposite to the region at the peripheral edge of the through hole 9d (a region around the central region of the supporting layer 21). In a case where a print is made with an ink wherein the particles 22 are evenly dispersed in a binder when the supporting layer 21A is formed, the particles 22 are easily arranged also into the central region of the supporting layer 21; therefore, as illustrated in Fig. 3D, when the central region of the supporting layer 21A is removed, the particles 22 can be certainly prevented from being fixed to the central region of the supporting layer 21A. Thus, it is preferred to render the shape of the supporting layer 21A a rectangular or circular frame shape. The supporting layer 21A can easily be formed by printing a pattern having such a shape.

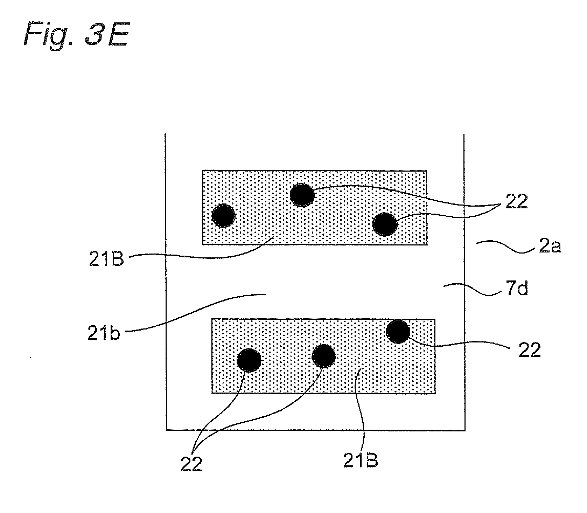

When an ink wherein the particles 22 are evenly dispersed in a binder is patterned to form the supporting layer 21A, the pattern shape is not limited to any rectangular frame shape, and may be any pattern shape as far as the pattern shape makes it possible that the particles 22 are not arranged in the central region thereof. For example, as illustrated in Fig. 3E, the pattern shape may be constituted by two rectangular-band-form supporting layers 21B and 21B arranged to leave a gap 21b in a region corresponding to the central region of the supporting layer 21A.

The pattern shape is not limited to any pattern printed so as to exclude the central region of the supporting layer 21. For example, the following manner may be used: a manner of printing a rectangle with an ink wherein the particles 22 are evenly dispersed in a binder, so as to form the supporting layer 21, adding compressed air lightly to the central region of the supporting layer 21 before the ink is dried, so as to shift the ink not dried from the central region of the supporting layer 21 to the peripheral region thereof, thereby making the rectangular hole 21a.

When the supporting layer 21 is laid, it is preferred to render the supporting layer 21 an electroconductive layer. Specifically, besides the particles 22, which have the spacer function, many fine electroconductive fillers are incorporated into the binder, which constitutes the supporting layer 21, inside the supporting layer 21, thereby giving electroconductivity to the supporting layer 21 itself. Under such a condition, the filler-incorporated mixture is painted into a predetermined area of the movable sheet 2. When the supporting layer 21 is not electroconductive, the individual electrode ends 6c, 7c, 6d and 7d of the movable sheet 2 cannot attain electrical connection in their regions covered with the supporting layer 21. Thus, about the size of the area where the supporting layer 21 is formed, design flexibility is small. On the other hand, when the supporting layer 21 is electroconductive, the design flexibility about the size of the area where the supporting layer 21 is formed is increased so that the production of the particles 22 becomes easy. The electroconductive filler may be a powder of an electroconductive metal such as silver, gold, copper, nickel, platinum, or palladium; a filler wherein an inorganic insulator such as alumina or glass, an organic polymer such as polyethylene, polystyrene, or divinylbenzene, or the like is used as a nucleus material, and any surface of the nucleus material is coated with an electroconductive layer of gold, nickel, or the like; or a filler wherein any surface of the nucleus material is coated with carbon, graphite, or the like. The electroconductive filler may be a filler in the form of flakes, spheres, short fibers, or the like.

It is more preferred to render the particles 22, which have the spacer function, electroconductive particles for the following reason: when the particles 22, which have the spacer function, are rendered electroconductive particles, the electroconductivity of the insides of the individual connection holes 16a becomes good. The electroconductive particles may be a powder of an electroconductive metal such as silver, gold, copper, nickel, platinum, or palladium; a filler wherein an inorganic insulator such as alumina or glass, an organic polymer such as polyethylene, polystyrene, or divinylbenzene, or the like is used as an electroconductive particle nucleus material, and any surface of the nucleus material is coated with an electroconductive layer of gold, nickel, or the like; a filler wherein any surface of the nucleus material is coated with an electroconductive layer of carbon, graphite, or the like; or other particles.

When both of the supporting layer 21 and the particles 22 have electroconductivity, the connection performance between the region 7f extended from the bus bar 7b of the lower electrode panel 3 and the electrode end 7d of the movable sheet 2 is stabilized for the following reason: even when the heating/drying shrinkage or normal-temperature-curing shrinkage of the electroconductive adhesive 15 causes a gap to be generated between the electroconductive adhesive 15 and the extended region 7f or electrode end 7d, electrical connection is attained through the supporting layer 21 and the particles 22 between the upper and lower circuits.

Incidentally, the present invention is not limited to any embodiment wherein the particles 22 are fixed onto the lower surface side of the movable sheet 2 as illustrated in Fig. 3A.

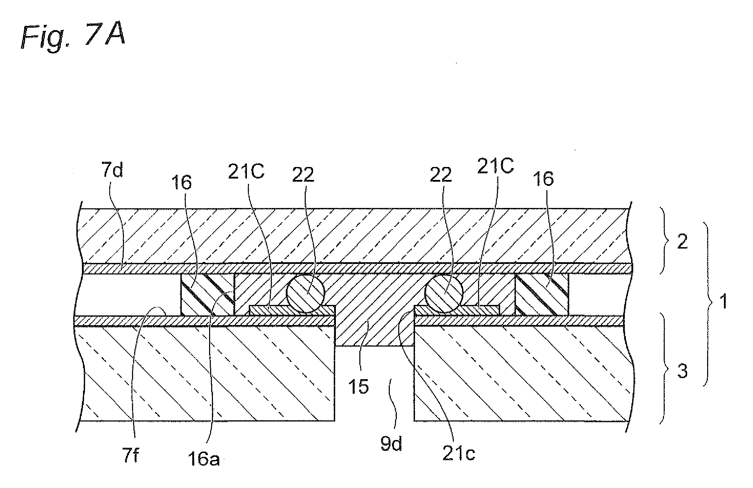

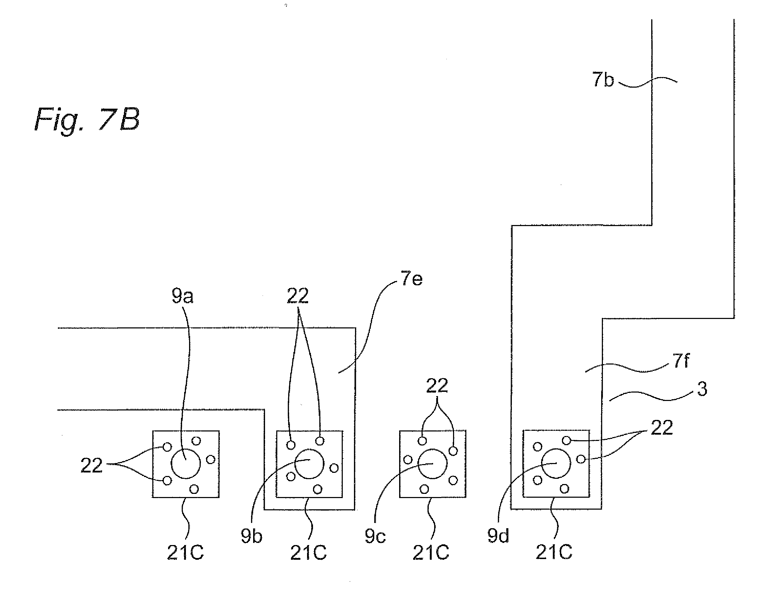

For example, as illustrated in Fig. 7A and Fig. 7B, the present invention may be made into an embodiment wherein the particles 22 are fixed on the upper surface side of the lower electrode panel 3 by a supporting layer 21C. This supporting layer 21C has, in the central region thereof, through holes 21c connected to the respective through holes 9a to 9d. About the through holes 21c, the size thereof is made equal to or more than the inside diameter of the through holes 9a to 9d. The upper limit value of the inside diameter of the through holes 21 is preferably 3 mm. If the inside diameter of the through holes 21 is more than 3 mm, the distance between the transparent window and the panel outer edge becomes large so that the frame is not easily made narrow.

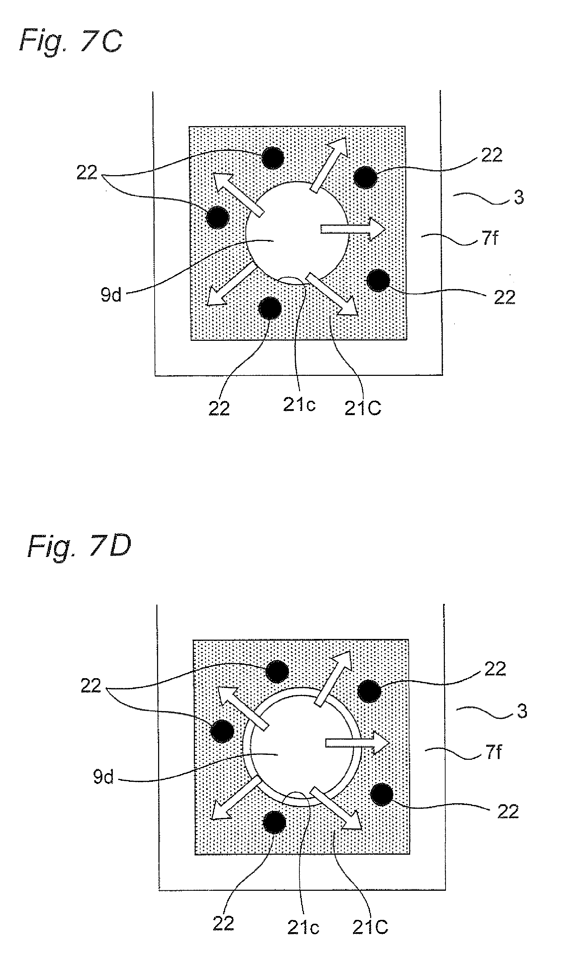

Fig. 7C is an enlarged plan view of the region 7f, which is a region extended from the lower circuit 7b in a case where the supporting layer 21C having the through holes 21c is fixed onto the upper surface side of the lower electrode panel 3. In Fig. 7C, white arrows each represent a flow of the electroconductive adhesive 15 injected from the through hole 9d in the lower electrode panel 3. Fig. 7C shows that the electroconductive adhesive 15 flows as represented by the white arrows between the particles 22, which constitute the dot spacers 30, so that the electroconductive adhesive 15 is filled into the connection holes 16a.

However, in a case where the supporting layer 21 to which the particles 22 are attached is fixed onto the upper surface side of the lower electrode panel 3 and then the lower electrode panel 3 and the supporting layer 21 are punched out to make the through hole 9d, wastes may be generated when the supporting layer 21 and the particles 22 are removed while the through hole is made.

In order to prevent this, for example, as illustrated in Fig. 7D, the supporting layer 21C is beforehand formed to have the through holes 21c the inside diameter of which is larger than that of the through hole 9d. In this case, it is unnecessary to make the through holes 21c afterwards. No wastes are generated when the supporting layer 21 and the particles 22 are removed while the through hole is made. Thus, the case is preferred.

Apart from the above, as illustrated in Fig. 3A, in a case where the particles 22 together with the supporting layer 21 are fixed onto the movable sheet 2 side, the generation of wastes of the supporting layer 21 and the particles 22 can be favorably prevented while the through hole 9d is made.

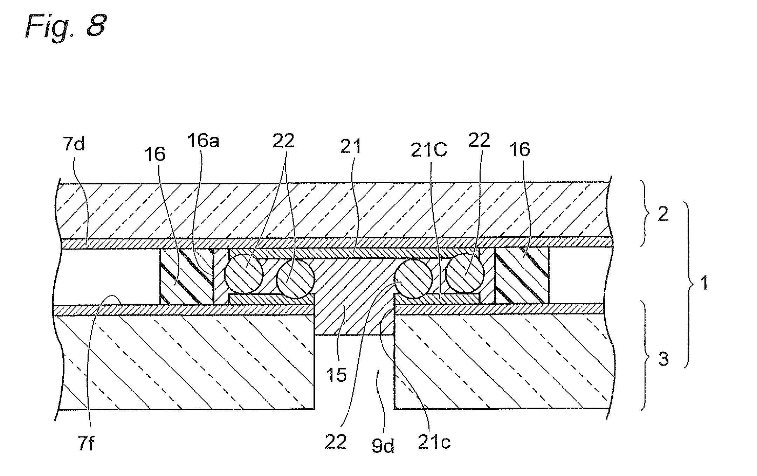

As illustrated in Fig. 8, by arranging the supporting layers 21 onto the lower surface side of the movable sheet 2 and the upper surface side of the lower electrode panel 3, respectively, the particles 22 may be fixed by the two supporting layers 21, which are upper and lower supporting layers. In this case, it is unnecessary that all the particles 22 are fixed onto both of the lower surface side supporting layer 21 of the movable sheet 2 and the upper surface side supporting layer 21 of the lower electrode panel 3; thus, it is sufficient for the case that the particles are fixed onto at least one of the supporting layers 21. As an example, in Fig. 8 is illustrated an example wherein the supporting layer 21 is arranged on the lower surface side of the movable sheet 2 and the supporting layer 21C is arranged on the upper surface side of the lower electrode panel 3.

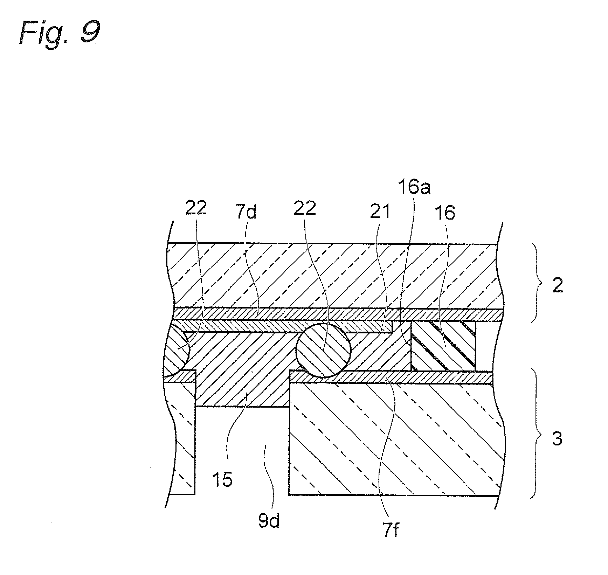

When the individual particles 22 are each formed to have a size permitting the member opposite to the member onto which the particles 22 are fixed and bonded to be pressed, an anchor effect is obtained. For example, when the particles 22 sink slightly into the lower electrode panel 3, physical connection between the movable sheet 2 onto which the particles 22 are fixed and bonded, and the lower electrode panel 3 opposite thereto is stabilized. Furthermore, when the particles 22 fixed and bonded onto the movable sheet 2 sink slightly into the lower electrode panel 3, physical connection of the circuits (the lower circuit 7f in Fig. 9) is stabilized in the lower electrode panel 3, so that the circuits less exfoliate. Also about the particles 22 fixed and bonded onto the lower electrode panel 3, the same anchor effect is obtained when the particles 22 sink slightly into the movable sheet 2. In a case where the particles 22 are made of an easily deformable material, the sinking amount of the particles 22 into the opposite member is decreased. Instead of the decrease, the contact area with the opposite member is increased so that the same effect is obtained.

The present invention is not limited to any product wherein the supporting layer 21 is arranged for each of the upper circuits 7d, 6d, 7c and 6d. The present invention may be a product wherein a single supporting layer 21, 21A, 21B or 21C is arranged for the plural upper circuits 7d, 6d, 7c and 6d.

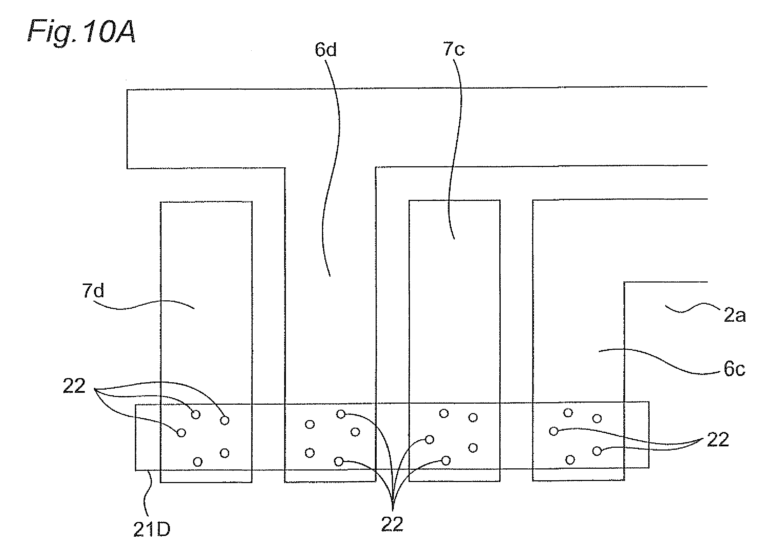

For example, as illustrated in Fig. 10A, it is allowable to arrange a rectangular-band-form supporting layer 21D onto the lower surface side of the movable sheet 2 to extend over the plural upper circuits 7d, 6d, 7c and 6d adjacent to one another, and fix the particles 22 onto each of the upper circuits 7d, 6d, 7c and 6d. This Fig. 10A is a plan view of a state that the upper electrode sheet 2a is turned upside down and then the lower surface of the upper electrode sheet 2a is directed upwards as the situation of the particles 22 and the supporting layer 21D supporting the particles 22 is well understandable. The rectangular-band-form supporting layer 21D is arranged in such a manner that the connection region of the four upper circuits 7d, 6d, 7c and 6d is covered with the single layer 21D; however, of course, the arrangement is not limited thereto. The single rectangular-band-form supporting layer 21D may be arranged in such a manner that the connection region of two or three upper circuits is covered therewith.

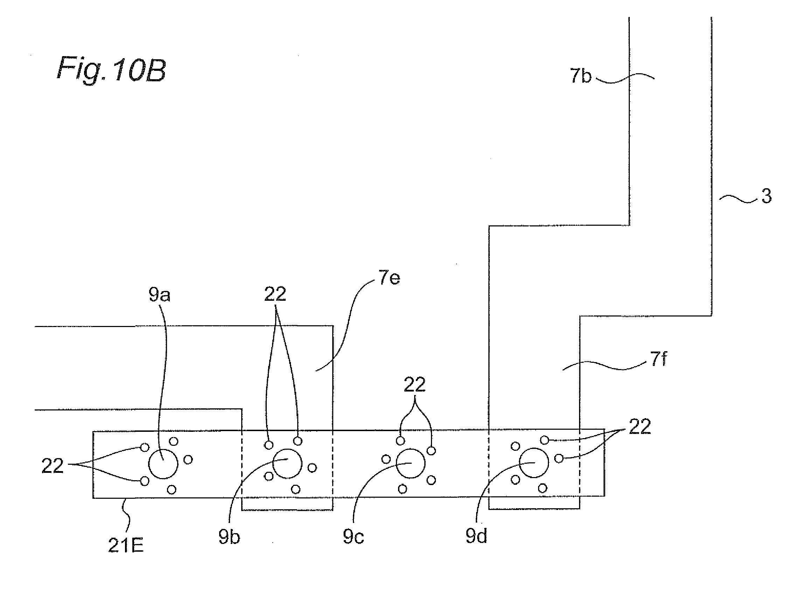

As illustrated in Fig. 10B, it is allowable to arrange a rectangular-band-form supporting layer 21E onto the upper surface side of the lower electrode panel 3 to extend over the plural extended regions 7e and 7f adjacent to each other, which are regions extended from the bus bars 7a and 7b, respectively, that is, to extend over the upper surface side positions of the lower electrode panel 3 that are at the peripheral edges of the through holes 9a, 9b, 9c and 9d, and fix the particles 22 to a position at the peripheral edge of each of the through holes 9a, 9b, 9c and 9d. The rectangular-band-form supporting layer 21E is arranged in such a manner that positions at the peripheral edges of the four through holes 9a, 9b, 9c and 9d are covered with the single layer 21E; however, of course, the arrangement is not limited thereto. The single rectangular-band-form supporting layer 21E may be arranged in such a manner that positions at the peripheral edges of two or three through holes are covered therewith.

The spacers 30 are not limited to the particles 22, and may be prismatic spacers, or columnar spacers as described below, or the like. In other words, the spacers 30 may have any shape as far as the spacers can exhibit each of a function of permitting gaps between regions at the peripheral edges of the through holes 9a to 9d to be kept to such a degree that depressions in the movable sheet are decreased, and a function of not hindering the electroconductive adhesive 15 injected from the through holes 9a to 9d from being filled into the connection holes 16a. The material thereof is preferably electroconductive in the same manner as the particles 22.

As an example thereof, the following will describe the prismatic spacers, giving examples thereof.

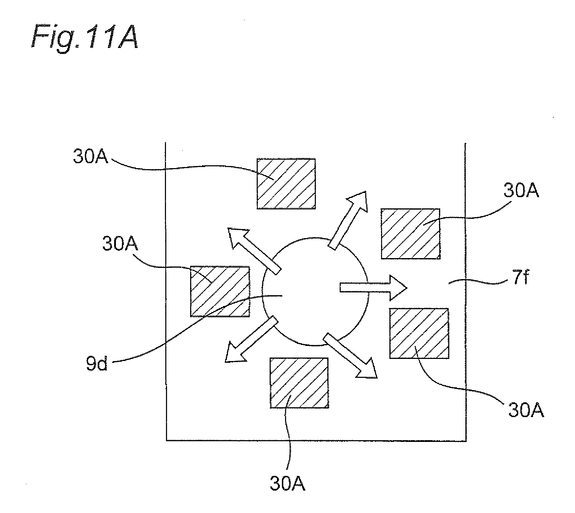

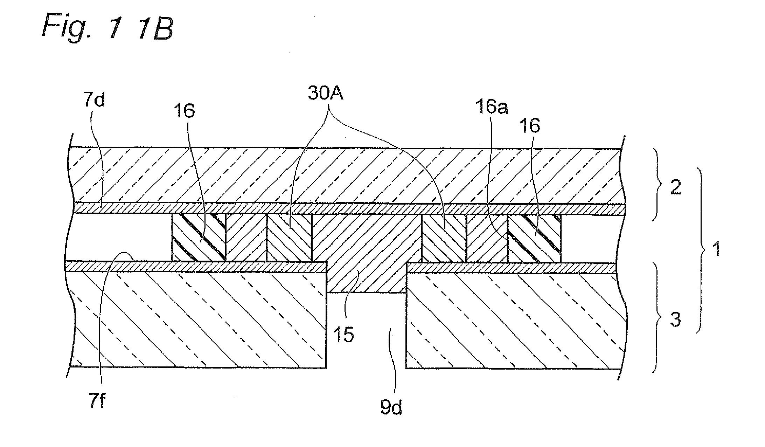

Fig. 11A and Fig. 11B are, respectively, an enlarged plan view and a sectional side view illustrating an example wherein plural prismatic spacers 30A are fixed in the region 7f extended from the lower circuit 7b in Fig. 2 without using the particles 22.

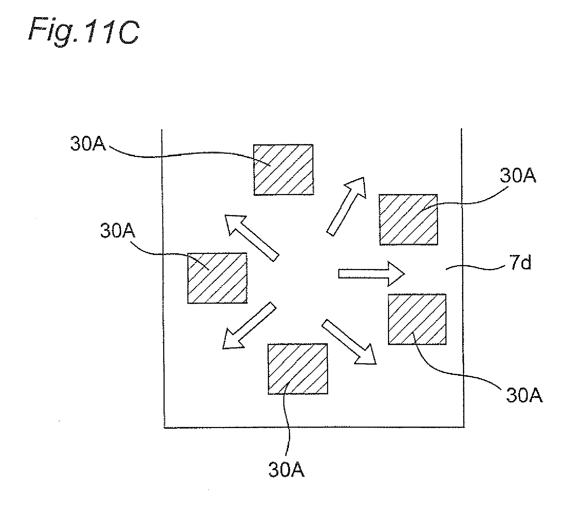

Fig. 11C is a plan view illustrating an example wherein the plural prismatic spacers 30A are fixed in a region of the upper circuit 7d in Fig. 2 which is opposite to the region at the peripheral edge of the through hole 9d without using the particles 22 in the same manner as in Fig. 11A.

In Figs. 11A to 11C, each of the spacers 30A may be formed by a pattern of, for example, a synthetic resin (by, for example, screen printing). The used synthetic resin is preferably a UV curable resin or a two-component curable resin. Since the resin does not contain any solvent, the thickness can be maintained with high precision.

According to the embodiment, the plural spacers 30 are fixed and arranged between the upper surface, at the peripheral edges of the through holes 9a to 9d, of the lower electrode panel 3 of the touch-input-function added protective panel 1 and the upper electrode sheet 2a and further in the individual connection holes 16a in the adhesive layer 16, so as to be separated from one another. From the through holes 9a to 9d, the electroconductive adhesive 15 is filled into the connection holes 16a, the gap interval of which is maintained by the spacers 30. For this reason, the injection of the electroconductive adhesive 15 can be smoothly filled into every portion of each of the connection holes 16a in the adhesive layer 16 for bonding the lower electrode panel 3 and the upper electrode sheet 2a. In other words, for example, the electroconductive adhesive 15 is certainly filled into the connection holes 16a, and further the following can be electrically connected to one another with certainty: the electrodes 6c, 7c, 6d and 7d of the upper electrode sheet 2a, or the electrodes 7e and 7f of the lower electrode panel 3, which face the connection holes 16a; the electroconductive adhesive 15 in the connection holes 16a; and the pins 11, 12, 13 and 14 of the FPC 10, which are inserted into the through holes 9a to 9d connected to the connection holes 16a. Thus, it is possible to heighten the reliability of electrical conduction between the electrodes 6c, 7c, 6d, 7d, 7e and 7f and the pins 11, 12, 13 and 14. Accordingly, the connection reliability of the pin-attached FPC 10, which depends on the filling degree of the electroconductive adhesive 15, is improved.

Furthermore, the electroconductive adhesive 15 is filled from the through holes 9a to 9d into the connection holes 16a, the gap interval of which is maintained by the spacers 30, so that the injection of the electroconductive adhesive 15 can be attained in the state that no depression is generated in the movable sheet 2, which is a laminated film of the upper electrode sheet 2a and the decorative sheet 2b. Thus, the external appearance quality of the protective panel 1 is improved.

Also against the shrinkage of the electroconductive adhesive 15 when the adhesive is heated and dried or cured at normal temperature, the spacers 30 can resist the shrinkage stress. Thus, depressions in the movable sheet 2 are decreased so that the external appearance quality of the protective panel 1 is improved.

The following will describe working examples which are actual examples of the embodiments. In the description on the working examples, the reference numbers of the individual constituting elements of the embodiments are used in order to make corresponding relationship between the working examples and the embodiments easily understandable. However, this does not mean that the individual constituting elements are limited to those in the following working examples.

### <Working Example 1>

An ITO film of 20 nm thickness was formed on the whole of a surface of a PET film of 0.1 mm thickness as a lower transparent electrode forming substrate by sputtering, and the peripheral edge region of the ITO film was removed to prepare a lower transparent electrode 5 in the form of a rectangle having a large width. Bus bars 7a and 7b arranged to two sides of the lower transparent electrode 5 that were opposite to each other along the traverse direction thereof, and routing lines 7e and 7f for giving outputs from the respective bus bars to the outside were each formed by screen printing using a silver paste. A substrate-free transparent adhesive of 0.025 mm thickness was used to adhere an acrylic plate having the same length and width as the PET film and a thickness of 0.7 mm, as a protective panel body 3A, onto the surface of the PET film opposite to the surface thereof on which the lower transparent electrode 5 was formed. Thereafter, in the edge region thereof were made by drilling four through holes 9a, 9b, 9c and 9d of 1.5 mm inside diameter wherein metallic pins 11 to 14 of a pin-attached FPC 10, which will be described later, were to be inserted. In this way, a lower electrode panel 3 was yielded.

A PET film having the same length and width as the lower electrode panel 3 and a thickness of 125 µm was used, and an ITO film of 20 nm thickness was formed on the whole of a surface thereof by sputtering. The peripheral edge region of the ITO film was removed to prepare an upper transparent electrode 4 in the form of a rectangle having a large width. Bus bars 6a and 6b arranged to two sides of the upper transparent electrode 4 that were opposite to each other along the lengthwise direction thereof, and routing lines 6c and 6d (thickness: 35 µm) for giving outputs from the respective bus bars 6a and 6b to the outside were each formed by screen-printing a silver paste wherein many electroconductive fillers made of a silver powder (diameter: 10 µm) in the form of fine flakes were incorporated into a binder made of a polyester resin. In this way, an upper electrode sheet 2a was yielded.

Furthermore, a hard coat film of a PET substrate having the same length and width as the lower electrode panel 3 and a thickness of 0.075 mm was used, and a decorative layer 17 having a transparent window section 18 was formed onto its surface opposite to its hard coat surface by gravure printing, so as to yield a decorative sheet 2b. Thereafter, the decorative layer side surface of the decorative sheet 2b was adhered onto the surface of the upper electrode sheet 2a opposite to the transparent electrode side surface thereof through a substrate-free transparent adhesive 5d of 0.025 mm thickness. In this way, a movable sheet 2 was yielded.

Next, on the upper electrode sheet 2a in the movable sheet 2, plural dot spacers 30 were formed and arranged at positions opposite to regions, at the peripheral edges of the through holes 9a to 9d, of the upper surface of the lower electrode panel 3, so as to be separated from one another. Specifically, many electroconductive fillers made of a silver powder (diameter: 10 µm) in the form of fine flakes were incorporated into a binder made of a polyester resin to prepare a silver paste, and then to the silver paste were further added particles 22 having a spacer function and made of a nickel powder (particle diameter: 75 µm). The resultant was painted by a dispenser method. In this way, the nickel particles 22 were fixed by a supporting layer 21 made of the silver paste, so as to turn to individual dots of the dot spacers 30. The thickness of the supporting layer 21 itself, which was made of the silver paste, was 35 µm, and the portions to which the nickel particles 22 were fixed and bonded were projected by 40 µm.

Next, the lower electrode panel 3 and the movable sheet 2 were arranged to be opposite to each other in such a manner that the electrodes 5 and 4 formed on the elements 3 and 2, respectively, were made apart from each other. These were adhered onto each other through a frame-form double faced adhesive tape (thickness: 50 µm) (adhesive layer 16) obtained by punching out a region of the transparent window 18 and the individual connection holes 16. The resultant was then cut along the inside circumference edge of the decorative layer 17. By the adhesion, a gap having a thickness of 50 µm was made between the upper surface of the lower electrode panel 3 at the peripheral edges of the through holes 9a to 9d and the upper electrode sheet 2a. This gap was maintained by the plural dot spacers 30. The dot spacers 30 were 25 µm larger than the distance between the lower electrode panel 3 and the movable sheet 2; thus, the particles 22 constituting the dot spacers 30 pressed the lower electrode panel 3 so that an anchor effect for the lower electrode panel 3 was exhibited.

In the meantime, in a connection side end 10a of an FPC 10 wherein a silver paste was used to form a circuit, as an electroconductive section, on a surface of a polyimide film of 0.075 mm thickness, four metallic-pin-fixing holes of 2.0 mm inside diameter were made by drilling. Therein were inserted metallic pins 11 to 14 each having a pin shaft of 1.8 mm diameter and 1 mm length and a pin head portion of 2.8 mm diameter from the circuit side surface of the FPC 10. Furthermore, a polyimide film (coverlay film 10b) of 0.05 mm thickness was adhered thereto so as to cover the circuit of the FPC 10 and the head portions of the metallic pins 11 to 14 (for example, reference number 14a in the metallic pin 14) . In this way, the pin-attached FPC 10 was yielded.

Thereafter, an ink of the electroconductive adhesive 15 was injected into the through holes 9a to 9d made in the lower electrode panel 3 by a dispenser, and then the metallic pins 11 to 14 of the pin-attached FPC 10 were inserted into the through holes 9a to 9d from the inlets thereof. This electroconductive adhesive 15 was an agent wherein a flake-form silver powder having a particle diameter of 10 µm was incorporated into a binder made of a silicone resin.

Finally, while an ultrasonic inserting machine was used to apply ultrasonic vibration and pressure onto the head portions of the metallic pins 11 to 14, the shaft portions of the metallic pins 11 to 14 were inserted into the through holes 9a to 9d under the pressure. Thus, while the resin constituting the wall surfaces of the through holes 9a to 9d made in the lower electrode panel 3 was melted, the individual shaft portions of the metallic pins 11 to 14 were inserted thereinto. In this way, a touch-input-function added protective panel 1 for an electronic instrument display window was yielded.

### <Working Example 2>

The same process as in Working Example 1 was carried out except that the dot spacers 30 were not formed on the upper electrode sheet 2a side but were formed on the upper surface of the lower electrode panel 3 at the peripheral edges of the through holes 9a to 9d.

### <Working Example 3>

The same process as in Working Example 1 was carried out except that in Working Example 2, the dot spacers 30 were further formed on the upper surface of the lower electrode panel 3 at the peripheral edges of the through holes 9a to 9d.
Specifically, Working Example 3 was an example wherein as illustrated in Fig. 8, the dot spacers 30 were fixed onto the upper surface of the lower electrode panel 3 at the peripheral edges of the through holes 9a to 9d and the upper electrode sheet 2a.

In each of the touch-input-function added protective panels 1 of Working Examples 1 to 3, the plural dot spacers 30 were fixed and arranged between the upper surface of the lower electrode panel 3 at the peripheral edges of the through holes 9a to 9d and the upper electrode sheet 2, so as to be separated from one another. From the through holes 9a to 9d, the electroconductive adhesive 15 was filled into the gap maintained by the dot spacers 30. Thus, the protective panel 1 was excellent in the connection reliability of the FPC 10 and the external appearance quality thereof.

By properly combining arbitrary embodiment(s) or modification(s) or aspect(s) of the aforementioned various embodiments or modifications or aspects, the effects owned by each of them can be made effectual.

### Industrial Applicability

The touch-input-function added protective panel for an electronic instrument display window according to the present invention is excellent in reliability of its FPC connection region, and is useful for a portable information terminal such as a PDA (personal digital assistance) or a handy terminal, an OA (office automation) instrument such as a copying machine or a facsimile, a smart phone, a portable telephone, a portable game instrument, an electronic dictionary, a car navigation system, a small-sized PC (personal computer), any one of various home electrical appliances, or the like.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. A touch-input-function added protective panel for an electronic instrument display window, comprising:
a lower electrode panel (3) having, on an upper surface of a nonflexible protective panel body (3A), a lower transparent electrode (5) and a lower circuit (7a, 7b) located around the lower transparent electrode;
an upper electrode sheet (2a) arranged on an upper side of the lower electrode panel, having, on a lower surface of a flexible and transparent insulating film, an upper transparent electrode (4) located at a position opposite to the lower transparent electrode and an upper circuit (6a to 6d, 7c, 7d) located around the upper transparent electrode, and further bonded, at its peripheral edge region, to the lower electrode panel through an adhesive layer (16) so as to form an inter-electrode gap (35) between the upper transparent electrode and the lower transparent electrode;
a decorative sheet (2b) arranged on an upper side of the upper electrode sheet, having, in at least one surface of a flexible and transparent insulating film, a decorative layer (17) that hides the lower circuit and the upper circuit and forms a transparent window section (18), and further adhered onto an upper surface of the upper electrode sheet; and
an FPC (10) that takes out an electrical signal through a pin (11, 12, 13, 14) inserted into a through hole (9a, 9b, 9c, 9d) made in the lower electrode panel,
wherein the adhesive layer has a connection hole (16a) connected to the through hole, plural spacers (30) are fixed and arranged in the connection hole and between the upper surface, at the peripheral edge of the through hole, of the lower electrode panel and the upper electrode sheet, so as to be separated from one another, and an electroconductive adhesive (15) is filled from the through hole into the connection hole, a gap interval of an inside of which is maintained by the spacers.

2. The touch-input-function added protective panel for an electronic instrument display window according to claim 1, wherein the spacers are dot spacers, and dots of the dot spacers are each fixed and bonded to at least one of the lower electrode panel and the upper electrode sheet.

3. The touch-input-function added protective panel for an electronic instrument display window according to claim 1, wherein the spacers are dot spacers, and dots of the dot spacers are each a particle (22) fixed and bonded to at least one of the lower electrode panel and the upper electrode sheet.

4. The touch-input-function added protective panel for an electronic instrument display window according to claim 3, wherein the particle is fixed and bonded by fixing a supporting layer (21) that fixes the particle, to at least one of the lower electrode panel and the upper electrode sheet.

5. The touch-input-function added protective panel for an electronic instrument display window according to claim 4, wherein the supporting layer is a layer having electroconductivity.

6. The touch-input-function added protective panel for an electronic instrument display window according to any one of claims 1 to 5, wherein the spacers have electroconductivity.

7. The touch-input-function added protective panel for an electronic instrument display window according to any one of claims 3 to 5, wherein the particle is spherical.

8. The touch-input-function added protective panel for an electronic instrument display window according to any one of claims 1 to 5, wherein a height size of the spacers is larger than a gap interval size of the connection hole that is maintained, in the connection hole in the adhesive layer, by the spacers.

9. The touch-input-function added protective panel for an electronic instrument display window according to any one of claims 1 to 4, wherein the spacers are arranged around a position of the upper surface of the lower electrode panel which corresponds to an inside of the through hole, so as to be in positions except the position, which corresponds to the inside of the through hole.

10. The touch-input-function added protective panel for an electronic instrument display window according to claim 4 or 5, wherein the supporting layer has a frame shape having, at a position of the upper surface of the lower electrode panel which corresponds to an inside of the through hole, a through hole (21c), and the particles are fixed to regions of the supporting layer except the through hole in the supporting layer, whereby the particles are arranged around the position corresponding to the inside of the through hole.
